(19) Europäisches Patentamt
European Patent Office
Office européen des brevets

(11) EP 1 403 916 A2

(12) EUROPEAN PATENT APPLICATION

(43) Date of publication:
31.03.2004 Bulletin 2004/14

(51) Int Cl.$^7$: H01L 21/66

(21) Application number: 03019023.5

(22) Date of filing: 21.08.2003

(84) Designated Contracting States:
AT BE BG CH CY CZ DE DK EE ES FI FR GB GR HU IE IT LI LU MC NL PT RO SE SI SK TR
Designated Extension States:
AL LT LV MK

(30) Priority: 25.09.2002 JP 2002279397

(71) Applicant: NEC Electronics Corporation
Kawasaki, Kanagawa 211-8668 (JP)

(72) Inventors:
- Nakajima, Kazuhiro, NEC Electronics Corporation Kawasaki-shi, Kanagawa 211-8668 (JP)
- Kanba, Kouji, NEC Electronics Corporation Kawasaki-shi, Kanagawa 211-8668 (JP)

(74) Representative: Glawe. Delfs. Moll
Patentanwälte
Postfach 26 01 62
80058 München (DE)

# (54) Production process for producing semiconductor devices, semiconductor devices produced thereby, and test system for carrying out yield-rate test in production of such semiconductor devices

(57) In a production process for producing a plurality of semiconductor devices on chip areas (12) which are defined on a wafer (10), the wafer is processed such that each of the chip areas is produced as a semi-finished semiconductor device by forming a first wiring-arrangement section (16) on each of the chip areas. The wafer is subjected to a provisional yield-rate test in which it is examined whether each of the semi-finished semiconductor devices on the wafer is acceptable or unacceptable to calculate a yield-rate of acceptable semi-finished semiconductor devices. When the wafer passes the provisional yield-rate test, the wafer is further processed such that each of the chip areas is produced as a finished semiconductor device by forming a second wiring-arrangement section (48) on the first wiring-arrangement section.

Fig. 1

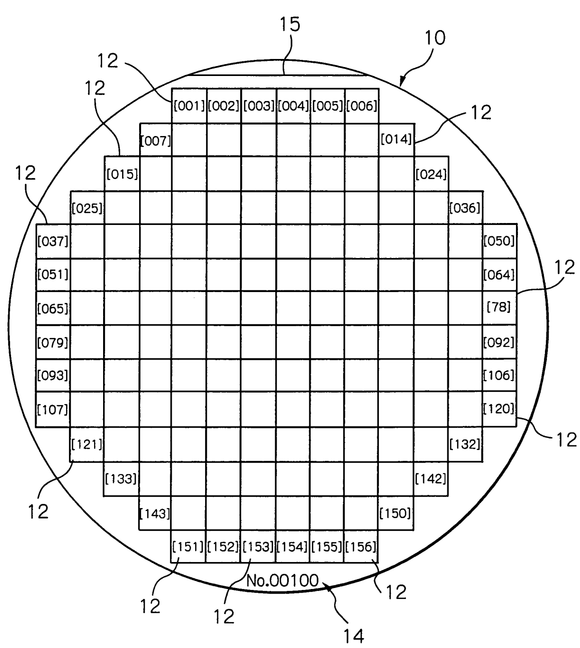


EP 1 403 916 A2

## Description

### BACKGROUND OF THE INVENTION

### Field of the Invention

The present invention relates to a production process for producing semiconductor devices, such as custom-made semiconductor devices or the like. Also, the present invention relates to such semiconductor devices per se, and a test system for carrying out a yield-rate test of the semiconductor devices in the production of the semiconductor devices.

### Description of the Related Art

In general, in mass-production of semiconductor devices, a plurality of silicon wafers are prepared, and a surface of each silicon wafer is sectioned into a plurality of chip areas by forming grid-like fine grooves ( i . e. scribe lines) in the silicon wafer. Then, the silicon wafer is processed by various methods, such as a photolithography method, a sputtering method, a chemical vapor deposition method, an etching method and so on, so that a multi-layered wiring-arrangement is formed on each of the chip areas, with the multi-layered wiring-arrangement being composed of metal circuit pattern layers and insulation layers alternately laminated on each of the chip areas. In short, each of the chip areas is substantially produced as a finished semiconductor device by forming the multi-layered wiring-arrangement thereon. Thereafter, the silicon wafer is subjected to a dicing process such that the plurality of semiconductor devices (i.e. bare chips) are individually cut and separated from each other.

When the semiconductor devices are constituted as custom-made semiconductor devices, the aforesaid multi-layered wiring-arrangement is sectioned into a basic wiring-arrangement section and a custom-purpose wiring-arrangement section. Namely, first, the basic wiring-arrangement section is formed on each of the chip areas, and then the custom-purpose wiring-arrangement section is formed on the basic wiring-arrangement section such that an insulation layer is intervened therebetween, with the basic and custom-purpose wiring-arrangement sections being suitably connected to each other through the intermediary of via-holes formed in the intervening insulation layer.

Conventionally, although the formation of the custom-purpose wiring-arrangement section on the basic wiring-arrangement section is completed, the custom-purpose wiring-arrangement section per se is not still customized. Namely, an uppermost circuit pattern, which is formed in an upper most metal circuit pattern layer of each custom-purpose wiring-arrangement section, is merely constituted so as to be rearranged in accordance with a customer's request. In short, each of the chip areas is produced as a semi-finished semiconductor device on the silicon wafer.

Also, conventionally, before the rearrangement or customization of the custom-purpose wiring-arrangement sections is performed, the silicon wafer is subjected to a first yield-rate test in which it is examined whether or not there are defects in the multi-layered wiring-arrangement formed on each of the chip areas, as disclosed in, for example, Japanese Laid-Open Patent Publication (KOKAI) No. SHO-62-183135. Namely, in the first yield-test, it is examined whether each of the semi-finished semiconductor devices on the silicon wafer is acceptable or unacceptable. When a yield rate of the acceptable semi-finished semiconductor devices is smaller than a predetermined permissible rate, the silicon wafer concerned is scrapped or returned to a wafer-manufacturing factory without rearranging or customizing the wiring-arrangement sections of the semi-finished semiconductor devices.

On the other hand, when the yield rate of the acceptable semi-finished semiconductor devices is larger than the predetermined permissible rate, the silicon wafer concerned is subjected to a customization process in which the custom-purpose wiring-arrangement section of the multi-layered wiring-arrangement of each semi-finished semiconductor device is rearranged in accordance with a customer's request. Namely, the customization is curried out by locally cutting the circuit pattern formed in the uppermost metal circuit pattern layer of the custom-purpose wiring-arrangement section, using a photolithography method and an etching method, such that the uppermost circuit pattern concerned is rearranged in accordance with the customer's request, resulting in production of the finished semiconductor devices on the silicon wafer.

As well known, in the customization using the photol ithography method, a photo-resist layer is formed on the uppermost metal circuit pattern layer of the custom-purpose wiring-arrangement section, but it is impossible to make a thickness of the photo-resist layer uniform, because the surface of the uppermost metal circuit pattern layer is irregular due to the circuit pattern formed therein. Thus, it is difficult to properly and accurately achieve the customization of the circuit pattern of the uppermost metal circuit pattern layer due to the irregularity of the thickness of the photo-resist layer, and thus the customized circuit pattern is liable to have defects, resulting in a decline in productivity of the finished semiconductor devices.

Conventionally, after the customization of the custom-purpose wiring-arrangement sections is performed, the silicon wafer is subjected to a second yield-rate test in which it is examined whether or not the customization is properly achieved in each of the custom-purpose wiring-arrangement sections of the multi-layered wiring-arrangement on the chip areas of the silicon wafer. Namely, in the second yield-test, it is examined whether each of the finished semiconductor devices on the silicon wafer is acceptable or unacceptable. Then, the silicon wafer is sorted in accordance with a yield rate of the acceptable finished semiconductor devices produced thereon. Thereafter, the silicon wafer is subjected to a dicing process such that the plurality of finished semiconductor devices (i.e. bare chips) are individually cut and separated from each other.

Note, when the yield rate of the acceptable finished semiconductor devices is too low, the silicon wafer concerned is scrapped or returned to a wafer-manufacturing factory.

A defect may occur in each of the basic wiring-arrangement sections formed on the chip areas of the silicon wafer. When the number of basic wiring-arrangement sections having the defects is so great that the silicon wafer concerned cannot pass the aforesaid first yield-rate test, it is useless to further form the custom-purpose wiring-arrangement sections on the basic wiring-arrangement sections. Nevertheless, conventionally, as is apparent from the foregoing, it is impossible to avoid the useless formation of the custom-purpose wiring-arrangement sections. Also, conventionally, it is difficult to properly and accurately achieve the customization of the custom-purpose wiring-arrangement sections, as already discussed above.

In any event, the aforesaid conventional production process fails to efficiently produce semiconductor devices, such as custom-made semiconductor devices or the like, at low cost.

## SUMMARY OF THE INVENTION

Therefore, a main object of the present invention is to provide a production process in which a plurality of semiconductor devices, such as custom-made semiconductor devices or the like, can be efficiently produced at low cost.

Another object of the present invention is to provide to a semiconductor device which is produced in accordance with the aforesaid production process.

Yet another object of the present invention is to provide yield-rate test systems used in the middle of the production process of the semiconductor devices.

In accordance with a first aspect of the present invention, there is provided a production process for producing a plurality of semiconductor devices on chip areas which are defined on a wafer. The production process comprises steps of processing the wafer such that each of the chip areas is produced as a semi-finished semiconductor device by forming a first wiring-arrangement section on each of the chip areas, subjecting the wafer to a provisional yield-rate test in which it is examined whether each of the semi-finished semiconductor devices on the wafer is acceptable or unacceptable, and further processing the wafer such that each of the chip areas is produced as a finished semiconductor device by forming a second wiring-arrangement section on the first wiring-arrangement section when the wafer passes the provisional yield-rate test.

A yield-rate of acceptable semi-finished semiconductor devices may be found in the provisional yield-rate test. In this case, it is determined that the wafer has passed the provision yield-rate test when the yield-rate exceeds a predetermined permissible rate.

The first wiring-arrangement section may be formed as a basic wiring-arrangement section to define plural kinds of basic electronic component formation areas, such as a random access memory formation area, flip-flop formation area, logic circuit formation area and so on, in each of the chip areas, and the second wiring-arrangement section may be formed as a customized wiring-arrangement section to establish electrical interconnections among the basic electrical component formation areas in accordance with a customer's request.

The basic wiring-arrangement section has a plurality of electrode pads formed on an uppermost surface thereof, for carrying out the aforesaid provisional yield-rate test.

Preferably, the production process further comprises steps of subjecting the wafer to a genuine yield-rate test in which it is examined whether each of the finished semiconductor devices on the wafer is acceptable or unacceptable, and finally processing the wafer when the wafer passes the genuine yield-rate test. The customized wiring-arrangement section has a plurality of electrode pads formed on an uppermost surface thereof, and these electrode pads are utilized for carrying out the genuine yield-rate test.

A yield-rate of acceptable finished semiconductor devices may be found in the genuine yield-rate test. In this case, it is determined that the wafer has passed the genuine yield-rate test when the yield-rate exceeds a predetermined permissible rate.

The basic wiring-arrangement section may be formed as a multi-layered wiring-arrangement section composed of at least two metal circuit pattern layers and at least one insulation layer alternately laminated on each of the chip areas, and also the customized wiring-arrangement section may be formed as a multi-layered wiring-arrangement section composed of at least two metal circuit pattern layers and at least one insulation layer alternately laminated on the basic wiring-arrangement section.

In accordance with a second aspect of the present invention, there is provided a plurality of semi-finished semiconductor devices formed on chip areas defined on a wafer, which comprises a wiring-arrangement section formed on each of the chip areas, and a plurality of electrode pads formed on an uppermost surface of the wiring-arrangement section, the electrode pads being only used to examine whether or not there is a defect in the wiring-arrangement section. When the aforesaid wiring-arrangement section is defined as a first wiring-arrangement section, each of the chip areas is produced as a finished semiconductor device by forming a second wiring-arrangement section on the first wiring-arrangement section.

In accordance with a third aspect of the present invention, there is provided a plurality of finished semiconductor devices formed on chip areas defined on a wafer, which comprises a first wiring-arrangement section formed on each of the chip areas, a plurality of electrode pads formed on an uppermost surface of the first wiring-arrangement section, which are only used to examine whether or not there is a defect in the first wiring-arrangement section, a second wiring-arrangement section formed on the first wiring-arrangement section, and a plurality of electrode pads formed on an uppermost surface of the second wiring-arrangement section, which are utilized to examine whether or not there is a defect in second wiring-arrangement section.

In the second and third aspects of the present invention, the first wiring-arrangement section may be formed as a basic wiring-arrangement section to define plural kinds of basic electronic component formation areas, such as a random access memory formation area, flip-flop formation area, logic circuit formation area and so on, in each of the chip areas, and the second wiring-arrangement section may be formed as a customized wiring-arrangement section.to establish electrical interconnections among the basic electrical component formation areas in accordance with a customer's request.

In accordance with a fourth aspect of the present invention, there is provided a semiconductor device comprising a chip base, a first wiring-arrangement section formed on the chip base, a plurality of electrode pads formed on an uppermost surface of the first wiring-arrangement section, and a second wiring-arrangement section formed on the first wiring-arrangement section. The plurality of electrode pads are allowed to remain on the uppermost surface of the first wiring-arrangement section which has been examined using the electrode pads to determine whether or not there are defects in the first wiring-arrangement section. Similar to the second and third aspects of the present invention, the first wiring-arrangement section may be formed as a basic wiring-arrangement section to define plural kinds of basic electronic component formation areas in each of the chip areas, and the second wiring-arrangement section is formed as a customized wiring-arrangement section to establish electrical interconnections among the basic electrical component formation areas in accordance with a customer's request.

In accordance with a fifth aspect of the present invention, there is provided a provisional yield-rate test system for testing a wafer having a plurality of semi-finished semiconductor devices formed on each of chip areas defined on the wafer. The provisional yield-rate test system comprises an examination system that examines whether each of the semi-finished semiconductor devices is acceptable or unacceptable, a yield-rate calculation system that calculates a yield-rate of acceptable semi-finished semiconductor devices based on the results of examination obtained by the examination system, and a yield-rate evaluation system that evaluates the calculated yield-rate to determine whether or not the wafer should be further processed.

The provisional yield-rate test system may further comprise a wafer identification system that identifies the wafer to be tested. Also, the provisional yield-rate test system may further comprise a storage system that stores the results of examination obtained by the examination system. The results of examination obtained by the examination system may be stored on a suitable storage medium as a chip table having a plurality of flag data corresponding to the chip areas on the wafer.

In accordance with a sixth aspect of the present invention, there is provided a genuine yield-rate test system for testing a wafer having a plurality of finished semiconductor devices formed on each of chip areas defined on the wafer, with each of the finished semiconductor devices being formed as a semi-finished semiconductor device by forming a first wiring-arrangement section, and then being completed by forming a second wiring-arrangement section on the first wiring-arrangement section. The genuine yield-rate test system comprises a storage medium that stores results of examination in which it has been examined whether each of the semi-finished semiconductor devices is acceptable or unacceptable, a determination system that determines whether each of the semi-finished semiconductor devices has been acceptable or unacceptable, an examination system that examines whether each of the finished semiconductor devices is acceptable or unacceptable only when it is determined by the determination system that a corresponding semi-finished semiconductor device has been found acceptable, a yield-rate calculation system that calculates a yield-rate of acceptable finished semiconductor devices based on the results of examination obtained by the examination system, and a yield-rate evaluation system that evaluates the calculated yield-rate to determine whether or not the wafer should be further processed.

The genuine yield-rate test system may further comprise a wafer identification system that identifies the wafer to be tested. Also, the genuine yield-rate test system may further comprise a storage system that stores the results of examination obtained by the examination system. The results of examination obtained by the examination system may be stored on a suitable storage medium as a chip table having a plurality of flag data corresponding to the chip areas on the wafer.

## BRIEF DESCRIPTION OF THE DRAWINGS

The above objects and other objects will be more clearly understood from the description set forth below, with reference to the accompanying drawings, wherein:

Figure 1 is a plan view of a silicon wafer having a plurality of chip areas, each of which is produced as a semi-finished semiconductor device by a production process according to the present invention;

Figure 2 is a plan view representatively showing one of the chip areas shown in Fig. 1;

Figure 3 is a partial enlarged view of Fig. 2;

Figure 4 is a partial cross-sectional view of the semi-finished semiconductor device, taken along the IV-IV line of Fig. 3;

Figure 5 is a partial cross-sectional view corresponding to Fig. 4, showing a finished semiconductor device which is produced on the chip areas by further processing the semi-finished semiconductor device;

Figure 6 is a plan view of the finished semiconductor device shown in Fig. 4;

Figure 7 is a block diagram of an embodiment of a test system for carrying out a provisional yield-rate test and a genuine yield-rate test, according to the present invention;

Figure 8 is a flowchart of a provisional yield-rate test routine which is executed in a system control unit to achieve the provisional yield-rate test;

Figure 9 is a conceptual view showing a chip table defined in a random access memory (RAM) contained in the system control unit during the execution of the provisional yield-rate test routine;

Figure 10 is a flowchart of an examination routine executed as a subroutine in the provisional yield-rate test routine;

Figure 11 is a flowchart of a yield-rate calculation/evaluation routine executed as a subroutine in the provisional yield-rate test routine;

Figure 12 is a flowchart of a genuine yield-rate test routine which is executed in the system control unit to achieve the genuine yield-rate test;

Figure 13 is a flowchart of an examination routine executed as a subroutine in the genuine yield-rate test routine;

Figure 14 is a flowchart of a yield-rate calculation/evaluation routine executed as a subroutine in the genuine yield-rate test routine;

Figure 15 is a representative flowchart of the production process according to the present invention;

Figure 16 is a partial cross-sectional view taken along the XVI-XVI line of Fig. 17, showing a semi-finished semiconductor device which is produced on a chip area of a silicon wafer in accordance with a conventional production process; and

Figure 17 is a plan view of the semi-finished semiconductor device shown in Fig. 16.

## DESCRIPTION OF THE PREFERRED EMBODIMENTS

With reference to Fig. 1, a silicon wafer, generally indicated by reference 10, is shown by way of example. A surface of the silicon wafer 10 is sectioned into a plurality of chip areas 12 by forming grid-like fine grooves (i.e. scribe lines) in the silicon wafer 10, and the silicon wafer 10 is processed in accordance with the present invention, using various well known methods, such as a photolithography method, a sputtering method, a chemical vapor deposition method, an etching method and so on, so that a multi-layered wiring-arrangement is formed on each of the chip areas 12, whereby each of the chip areas 12 is produced as a finished semiconductor device.

The multi-layered wiring-arrangement is composed of a first wiring-arrangement section formed on each of the chip areas 12, and a second wiring-arrangement section formed on the first wiring-arrangement section. In this embodiment, the respective first and second wiring-arrangement sections may be referred to as a basic wring-arrangement section and a customized wiring-arrangement section.

When the basic wiring-arrangement is formed on each of the chip areas 12, i.e. when each of the chip areas 12 is produced as a semi-finished semiconductor device, the silicon wafer 10 is subjected to a provisional yield-rate test in which it is examined whether or not there are defects in each of the basic wiring-arrangement sections. Namely, in the provisional yield-rate test, it is examined whether the individual semi-finished semiconductor devices are acceptable or unacceptable to thereby calculate a yield-rate of acceptable semi-finished semiconductor devices.

When the silicon wafer 10 passes the provisional yield-rate test, the silicon wafer 10 is further processed such that the customized wiring-arrangement section is formed on each of the basic wiring-arrangement sections in accordance with a customer's request, whereby each of the chip areas 12 is substantially produced as the finished semiconductor device. In other words, according to the present invention, the customization is completed at the same time when the formation of the customized wiring-arrangement section on each of the basic wiring-arrangement sections is carried out.

After the formation of the customized wiring-arrangement sections on the basic wiring-arrangement sections is carried out, the silicon wafer 10 is further subjected to a genuine yield-rate test in which it is examined whether or not there are defects in each of the customized wiring-arrangement sections. Namely, in the genuine yield-rate test, it is examined whether the individual finished semiconductor devices are acceptable or unacceptable.

In the production of the semiconductor devices, a plurality of silicon wafers 10 are prepared for a mass-production of the semiconductor devices. These silicon wafers 10 are identical to each other, but it is necessary to identify each of these silicon wafers 10 in the aforesaid provisional and genuine yield-rate tests, as stated in detail hereinafter. To this end, the silicon wafers 10 are numbered by serial wafer-numbers so as to be distinguishable from each other. Note, in Fig. 1, by way of example, the silicon wafer 10 is numbered by a serial wafer-number "No. 00100", indicated by reference 14, by way of example.

Also, in the provisional and genuine yield-rate tests, it is necessary to identify each of the chip areas 12, and thus the plurality of chip areas 12 are numbered by serial chip-numbers [001] to [156], as representatively shown in Fig. 1. Namely, in the example shown in Fig. 1, the 156 chip areas 12 are defined on the surface of the silicon wafer 10, and are distinguishable from each other by the serial chip-numbers [001] to [156].

Of course, although the serial chip-numbers [001] to [156] are conveniently and representatively shown in Fig. 1, in reality, these serial chip-numbers [001] to [156] are not written in the chip areas 12. As shown in Fig. 1, the silicon wafer 20 features an orientation flat 15 formed by cutting a part thereof, and the numbering of the chip areas 12 is carried out with respect to the orientation flat 14. Namely, it is possible to recognize a chip-number of each chip area 12 based on a relative position of the chip area 12 concerned in relation to the orientation flat 14.

With reference to Fig. 2, one of the chip areas 12, which is produced as a semi-finished semiconductor device, is representatively illustrated. Also, Figure 3 shows a part of the chip area 12 in an enlarged view, and Figure 4 shows a partial cross section taken along the IV-IV line of Fig. 3.

As state above, the semi-finished semiconductor device is produced by forming a basic wiring-arrangement section on the chip area 12, and the basic wiring-arrangement section is generally indicated by reference 16 in Fig. 4. For example, the formation of the basic wiring-arrangement section 16 is carried out such that some kinds of basic electronic component formation areas 18, 20, 22, 24, and 26 are defined on the chip area 12, as shown in Fig. 2. In this embodiment, the respective areas 18, 20, 22, 24, and 26 are a random access memory ( RAM) formation area, a flip-flop (FF) formation area, a logic circuit formation area, an input/out buffer formation area, and an electrode pad formation area.

The random access memory formation area 18 includes a plurality of memory cells formed therein, the flip-flop formation area 20 includes a plurality of flip-flops formed therein, and the logic circuit formation area 22 includes a plurality of logic elements formed therein. Also, the input/out buffer formation area 24 surrounds the formation areas 18, 20 and 22, and includes a plurality of input/out buffers formed therein. With reference to Fig. 3, each of the input/output buffers is conceptually illustrated as a block, which is indicated by reference 28. As is apparent from Figs. 2 and 3, a plurality of electrode pads 30 and a plurality of conductive leads 32 are formed and arranged on the electrode pad formation area 26 defined on the second insulation layer 42 and surrounding the input/output buffer formation area 24, with each of the conductive leads 32 integrally extending from a corresponding electrode pad 30.

The basic wiring-arrangement section 16 is formed on the chip area 12, using various well known methods such as a photolithography method, a sputtering method, a chemical vapor deposition method, an etching method and so on, and the formation of the basic wiring-arrangement section 16 is carried out, for example, as follows:

First, an oxide layer (silicon dioxide) 13 of the chip area 12 is patterned such that a plurality of opening areas are formed in the oxide layer 13, and active regions are produced in each of the opening areas by injecting suitable impurities into the opening areas. With reference to Fig. 4, an N type-impurity-injection active region 34 is representatively shown by way of example, and is produced in the input/output buffer formation area 24 so as to form a part of the input/output buffer 28 included in the input/output buffer formation area 24.

Thereafter, the patterned chip area 12 is metallized such that a metal layer is formed thereon, and the metal layer is patterned such that a first metal circuit pattern layer 36 is formed on the chip area 12, as shown in Fig. 4. Then, a first insulation layer 38 is formed on the first metal circuit pattern layer 36, and via-holes (not shown) are suitably formed in the first insulation layer 38.

The first insulation layer 38 is metallized such that a metal layer is formed thereon, and the metal layer is patterned such that a second metal circuit pattern layer 40 is formed on the first insulation layer 38, as shown in Fig. 4, with the first and second metal circuit pattern layers 36 and 40 being mutually and electrically connected to each other through the intermediary of the via-holes formed in the first insulation layer 38. Then, a second insulation layer 42 is formed on the second metal circuit pattern layer 40, and via-holes (not shown) are suitably formed in the second insulation layer 42.

The second insulation layer 42 is metallized such that a metal layer is formed thereon, and the metal layer is patterned such that a third metal circuit pattern layer 44 is formed on the second insulation layer 42, as shown in Fig. 4, with the second and third metal circuit pattern layers 40 and 44 being mutually and electrically connected to each other through the intermediary of the via-holes formed in the second insulation layer 42. Note, when the third metal circuit pattern layer 44 is formed, the formation of the electrode pads 30 and the conductive leads 32 on the electrode pad formation area 26 is simultaneously carried out.

As representatively shown in Fig. 4, each of the conductive leads 32 is electrically connected to the active region 34 of a corresponding input/output buffer 28 through the intermediary of a via-hole 46 formed in the first and second insulation layers 38 and 42. Namely, each of the electrode pads 30 is suitably connected to any one of the first, second and third metal circuit pattern layers 36, 40 and 44 in through the intermediary of a corresponding conductive lead 32, a corresponding via-hole 46, and a corresponding input/output buffer 28.

After the completion of the formation of the basic wiring-arrangement sections 16 on all the chip areas 12, i.e. after each of the chip areas 12 is produced as the semi-finished semiconductor device on the silicon wafer 10, the silicon wafer 10 is subjected to the aforesaid provisional yield-rate test. In the provisional yield-rate test, each of the electrode pads 30 is used only as a test pad, with a probe contact PC being contacted to the test pad 30, as shown in Fig. 4. Note, the provisional yield-rate test will be explained in detail hereinafter.

When the silicon wafer 10 passes the provisional yield-rate test, the silicon wafer 10 is further processed such that a customized wiring-arrangement section is formed on each of the basic wiring-arrangement sections 16 in accordance with a customer's request, whereby each of the chip areas 12 is substantially produced as a finished semiconductor device, as already stated above.

With reference to Fig. 5 corresponding to Fig. 4, the customized wiring-arrangement section, formed on the basic wiring-arrangement section 16, is generally indicated by reference 48. As stated above, the finished semiconductor device is produced by further forming the customized wiring-arrangement section on the basic wiring-arrangement section 16.

Similar to the basic wiring-arrangement section 16, the formation of the customized wiring-arrangement section 48 is carried out, using various well known methods, such as the photolithography method, the sputtering method, the chemical vapor deposition method, the etching method and so on.

First, a third insulation layer 50 is formed on the third metal circuit pattern layer 44, and via-holes (not shown) are suitably formed in the third insulation layer 38. Then, the third insulation layer 50 is metallized such that a metal layer is formed thereon, and the metal layer is patterned such that a fourth metal circuit pattern layer 52 is formed on the third insulation layer 50, as shown in Fig. 5, with the third and fourth metal circuit pattern layers 44 and 52 being mutually and electrically connected to each other through the intermediary of the via-holes formed in the third insulation layer 50.

A fourth insulation layer 54 is further formed on the fourth metal circuit pattern layer 52, and via-holes (not shown) are suitably formed in the fourth insulation layer 54. Then, the fourth insulation layer 54 is metallized such that a metal layer is formed thereon, and the metal layer is patterned such that a fifth metal circuit pattern layer 56 is formed on the fourth insulation layer 54, as shown in Fig. 5, with the fourth and fifth metal circuit pattern layers 52 and 56 being mutually and electrically connected to each other through the intermediary of the via-holes formed in the fourth insulation layer 52.

As already stated above, according to the present invention, since the formation of the customized wiring-arrangement section 48 is carried out in accordance with a customer's request, the customization is completed at the same time when the customized wiring-arrangement section 48 is formed on each of the basic wiring-arrangement sections 16.

According to the present invention, by the formation of the customized wiring-arrangement section 48, electrical interconnections are established among the access memory (RAM) formation area 18, the flip-flop (FF) formation area 20, the logic circuit formation area 22, and the input/out buffer formation area 24 in accordance with a customer's request. Thus, as already stated, the customization is completed at the same time when the customized wiring-arrangement section 48 is formed on each of the basic wiring-arrangement sections 16.

Note, when the customized wiring-arrangement section 48 is completed, an uppermost circuit pattern formed in the fifth metal circuit pattern layer 56 appears at an area corresponding to the random access memory formation area 18, flip-flop formation area 20, and logic circuit formation area 22, as shown in Fig. 6.

While the formation of the fifth metal circuit pattern layer 56 is being carried out, a plurality of electrode pads 58 and a plurality of conductive leads 60 are simultaneously formed on the fourth insulation layer 54 at an area corresponding to the electrode pad formation area 26, as shown in Figs. 5 and 6, with each of the conductive leads 60 integrally extending from a corresponding electrode pad 58.

As representatively shown in Fig. 5 by way of example, each of the conductive leads 60 is electrically connected to the active region 34 of a corresponding input/output buffer 28 through the intermediary of a via-hole 62 formed in the third and fourth insulation layers 50 and 54. Namely, in the example shown in Fig. 5, the conductive lead 60 is connected to the conductive lead 32 formed on the second insulation layer 42, resulting in the establishment of the electrical connection of the conductive lead 60 to the active region 34 of the input/output buffer 28.

After the completion of the formation of the customized wiring-arrangement sections 48 on all the chip areas 12, i.e. after each of the chip areas 12 is substantially produced as the finished semiconductor device on the silicon wafer 10, the silicon wafer 10 is subjected to the aforesaid genuine yield-rate test. In the genuine yield-rate test, as shown in Fig. 5, each of the electrode pads 58 is used as a test pad with which the probe contact PC is contacted, each electrode pad 58 per se serves as an input/output electrode terminal for the finished semiconductor device. Note, the genuine yield-rate test will be explained in detail hereinafter.

With reference to Fig. 7, an embodiment of a test system according to the present invention is illustrated as a block diagram, to carry out the aforesaid provisional and genuine yield-rate tests.

The test system, which is frequently called an LSI tester, comprises a system control unit 64 which contains a microcomputer having a central processing unit (CPU), a read-only memory (ROM) for storing programs and constants, a random-access memory (RAM) for storing temporary data, and an input/output (I/0) interface circuit.

The test system also comprises a hard disk drive 66 for driving a hard disk 68 on which yield-rate test programs, other various programs, various tables, various data and so on are stored. The system control unit 64 writes the various programs, tables and data on the hard disk 68 through the hard disk drive 66, and also reads them from the hard disk 68 through the hard disk drive 66, if necessary.

The test system further comprises a keyboard 69 for inputting various commands and data to the system control unit 64 though the I/0 interface circuit thereof. The test system is also provided with a display unit (CRT or LCD) 70 for displaying various command items, various information data and so on, and a mouse 71 for inputting a command to the system control unit 64 by clicking the mouse 71 on any one of the command items displayed on the display unit 70.

The test system comprises a test stage 72 on which a silicon wafer 10 is placed while either the provisional yield-rate test or the genuine yield-rate test is performed. Although a plurality of silicon wafers 10 are tested by the test system, each of the silicon wafers 10 can be properly and accurately oriented and positioned at a predetermined position on the test stage 72, using the orientation flat 15 (Fig. 1) of each silicon wafer 10 as a positioning mark. Although not shown in Fig. 7, the test system is provided with an automatic wafer transferring/positioning system, by which the silicon wafer 10 is transferred to and positioned at the predetermined position, and is removed therefrom after the test is completed.

The test system includes a movable test head 74 having a plurality of probe contacts PC, one of which is representatively shown in Figs. 4 and 5. The test head 74 is driven and moved by a mechanical drive system 76. Namely, the mechanical drive system 76 contains a drive mechanism to which the test head 76 is mechanically and movably connected, and electric drive motors for driving the drive mechanism to thereby move the test head 74. Note, in Fig. 7, the mechanical and movable connection of the test head 74 to the drive mechanism is symbolically and conceptually represented by an arrow-headed broken line 78 in Fig. 7. The drive motors of the mechanical drive system 76 are driven by a drive circuit 80 which is operated under control of the system control unit 64. Namely, the movement of the test head 74 is controlled by the system control unit 64 through the drive circuit 80. As shown in Fig. 7, the movable test head 74 is also associated with a signal processing circuit 82 which is operated under control of the system control unit 64.

While either the provisional yield-rate test or the genuine yield-rate test is performed, the movement of the test head 74 is controlled such that all the 156 chip areas 12, each of which is produced as a semi-finished semiconductor device, are scanned with the test head 74 in the order of the serial chip-numbers [001] to [156] (Fig. 1).

In particular, for example, when the provisional yield-rate test is performed, first, the test head 74 is moved from a home position to a position just above the semi-finished semiconductor device, identified by the chip-number [001], and is then moved down until the probe contacts PC are contacted to the electrode pads 30 on the chip area 12 concerned, as representatively shown in Fig. 4. Subsequently, the signal processing circuit 82 produces and outputs test signals to some probe contacts PC of the test head 74, and then receives response signals from other probe contacts PC of the test head 74. After the response signals are suitably processed in the signal processing circuit 82, these response signals are output to the system control unit 64, in which it is examined whether the semi-finished semiconductor device, which is formed on the chip area 12 identified by the chip-number [001], is acceptable or unacceptable on the basis of the response signals.

Thereafter, the test head 74 is lifted up and moved to a position just above the next chip area 12 identified by the chip-number [002], and then is moved down until the probe contacts PC are contacted to the electrode pads 30 on the chip area 12 concerned. Subsequently, it is examined whether the semi-finished semiconductor device, identified by the chip-number [002], is acceptable or unacceptable in substantially the same manner as mentioned above. This test operation is repeated until it is examined whether the last semi-finished semiconductor device, identified by the chip-number [156], is acceptable or unacceptable.

Note, while the genuine yield-rate test is performed, the test head 74 is moved and operated in substantially the same manner as in the provisional yield-rate test.

As shown in Fig. 7, the test system is provided with an image sensor 84 for detecting a wafer-number (e.g. "No. 00100" shown in Fig. 1) of a silicon wafer 10, and the image sensor 84 may be constituted as a CCD (charge-couple device) image sensor. The CCD image sensor 84 is associated with an image signal processor 86 which is operated under control of the system control unit 64. The CCD image sensor 84 detects the wafer-number as a frame of still image signals, and outputs to the image signal processor 86. The frame of still image signals are suitably processed in the image signal processor 86, and is then fed to the system control unit 64. The frame of still image signals are analyzed in the system control unit, whereby it is possible to recognize and identify the silicon wafer 10 to be tested.

Figure 8 shows a flowchart of a provisional yield-rate test routine which is executed in the system control unit 64 to achieve the aforesaid provisional yield-rate test. Note, the execution of the provisional yield-rate test routine is started by either operating a previously allocated function key on the keyboard 69 or double-clicking the mouse 71 on a provisional test staring item displayed on the display unit 70.

At step 801, it is monitored whether or not a silicon wafer 10 has been positioned at the predetermined position on the test stage 72 by the aforesaid automatic wafer transferring/positioning system. When the positioning of the silicon wafer 10 at the predetermined position is confirmed, the control proceeds to step 802, in which a wafer-number "WN" of the silicon wafer 10 is detected by analyzing a frame of still image signals obtained from the CCD image sensor 84 through the image signal processor 86.

After the detection of the wafer-number "WN" is completed, the control proceeds to step 803, a chip table is defined in the RAM of the system control unit 64 so as to be identified by the detected wafer-number "WN". For example, when the detected wafer-number "WN" is [00100], the definition of the chip table is carried out, as conceptually shown in Fig. 9. Namely, the chip table has 156 addresses [001] to [156] corresponding to the chip-numbers [001] to [156], and a flag data "FD" is stored in each of the addresses [001] to [156].

After the definition of the chip table in the RAM is completed, the control proceeds to step 804, in which an examination routine is executed as a subroutine to thereby examine whether each of semi-finished semiconductor devices, which are formed on the chip areas 12 of the silicon wafer 10 having the wafer number [00100], is acceptable or unacceptable. Note, the examination routine is explained in detail hereinafter, with reference to Fig. 10.

At step 805, a yield-rate calculation/evaluation routine is executed as a subroutine to thereby calculate a yield-rate of acceptable semi-finished semiconductor devices on the silicon wafer 10 concerned, and the silicon wafer 10 is evaluated in accordance with the calculated yield-rate. Note, the yield-rate calculation/evaluation routine is explained in detail hereinafter, with reference to Fig. 11.

At step 806, it is determined whether the provisional yield-rate test routine should be repeated, i.e. whether a silicon wafer 10 remains to be tested. When the existence of a remaining silicon wafer 10 is confirmed, the control returns to step 801. When there is no silicon wafer to be tested, the routine ends.

Figure 10 shows a flowchart of the examination routine executed in step 804 of Fig. 8.

At step 1001, a chip-number counter $C_{CN}$ is reset to "1", and, at step 1002, an acceptable-device counter $C_{AC}$ is reset to "0".

At step 1003, the test head 74 is moved to a semi-finished semiconductor device (12), which is identified by the chip-number "$C_{CN}$", by operating the drive circuit 80 under the system control unit 64. At this initial stage, since $C_{CN}$ = 1, first, the test head 74 is moved from the home position to a position just above the semi-finished semiconductor device (12) identified by the chip-number [001], and is then moved down toward the semi-finished semiconductor device concerned.

At step 1004, it is monitored whether the probe contacts PC of the test head 74 are in contact with the electrode pads 30 (Fig. 2) of the semi-finished semiconductor device identified by the chip-number "$C_{CN}$", and the movement of the test head 74 is stopped when the contact between the probe contacts PC and the electrode pads 30 is confirmed.

At step 1005, an examination of the semi-finished semiconductor device identified by the chip-number "$C_{CN}$" is performed by outputting test signals from the signal processing circuit 82 to some probe contacts PC of the test head 74. Then, at step 1006, it is determined whether the semi-finished semiconductor device concerned is acceptable or unacceptable on the basis of response signals, which are output from other probe contacts PC of the test head 74 in response to the aforesaid test signals.

When the semi-finished semiconductor device identified by the chip-number "$C_{CN}$" is acceptable, the control proceeds to step 1007, in which the count number of the acceptable-device counter $C_{AC}$ is incremented by "1". Then, at step 1008, a flag data FD, which is stored in an address corresponding to the chip-number "$C_{CN}$", is made to be "1". At this initial stage, since $C_{CN}$ = 1, the flag data FD stored in the address [001] is made to be "1".

On the other hand, when the semi-finished semiconductor device identified by the chip-number "$C_{CN}$" is unacceptable, the control proceeds from step 1006 to step 1009, in which the flag data FD concerned is made to be "0". At this initial stage, since $C_{CN}$ = 1, the flag data FD stored in the address [001] is made to be "0".

In either case, the control proceeds to step 1010, in which it is determined whether the count number of the chip-number counter $C_{CN}$ has reached "156". When the count number of the chip-number counter $C_{CN}$ has not reached "156", the control proceeds step 1011, in which the count number of the chip-number counter $C_{CN}$ is incremented by "1". Then, the control returns to step 1003, and the routine including steps 1003 to 1010 is repeatedly executed until the count number of the chip-number counter $C_{CN}$ has reached "156" (step 1010), i.e. until all the 156 semi-finished semiconductor devices have been examined. When the examination of all the semi-finished semiconductor devices is completed, the control returns to step 804 of Fig. 8.

Figure 11 shows a flowchart of the yield-rate calculation/evaluation routine executed in step 805 of Fig. 8.

At step 1101, the following calculation is carried out:

$$YR_S \leftarrow C_{AC}/156$$

Herein: $YR_S$ is a yield-rate of the acceptable semi-finished semiconductor devices, and is obtained by dividing a count number of the acceptable-device counter $C_{AC}$ by the total number "156" of the semi-finished semiconductor devices formed on the silicon wafer 10 concerned.

At step 1102, it is determined whether or not the yield-rate $YR_S$ is equal to or larger than a given permissible rate $PR_S$, which is previously input to the RAM of the system control unit 64 by suitable operating the keyboard 69. Also, it is possible to optionally vary the permissible rate $PR_S$ by suitably operating the keyboard 69.

At step 1102, when the yield-rate $YR_S$ is equal to or larger than the predetermined permissible rate $PR_S$, the control proceeds to step 1103, in which a pass message is displayed together with the calculated yield-rate $YR_S$ on the display unit 70 to announce that the silicon wafer 10 has passed the provisional yield-rate test. On the other hand, when the yield-rate $YR_S$ is smaller than the predetermined permissible rate $PR_S$, the control proceeds from step 1102 to 1104, in which a not-pass message is displayed together with the calculated yield-rate $YR_S$ on the display unit 70 to announce that the silicon wafer 10 has not passed the provisional yield-rate test.

In either case, at step 1105, the chip table (Fig. 9) is stored on the hard disk 68 through the hard disk drive 66. At step 1106, it is monitored whether or not the storage of the chip table on the hard disk 68 is completed.

After the completion of the storage of the chip table on the hard disk 68 is confirmed, the control proceeds to step 1107, in which the silicon wafer 10 is transferred to either a pass station or a not-pass station by the aforesaid automatic wafer transferring/positioning system in accordance with the test results. Namely, when the silicon wafer 10 has passed the provisional yield-rate test, it is transferred to the pass station, and, when the silicon wafer 10 has not passed the provisional yield-rate test, it is transferred to the not-pass station.

At step 1108, it is monitored whether or not the transfer of the silicon wafer 10 to either the pass station or a not-pass station is completed. After the completion of the transfer of the silicon wafer 10 to either the pass station or a not-pass station is confirmed, the control returns to step 805 of Fig. 8.

According to the present invention, as already stated hereinbefore, only a silicon wafer 10, which has passed the provisional yield-rate test, is further processed so that a customized wiring-arrangement section 48 is formed on each of the basic wiring-arrangement sections 16 on the passed wafer 10, whereby each of the chip areas 12 on the silicon wafers is substantially produced as a finished semiconductor device.

Figure 12 shows a flowchart of a genuine yield-rate test routine which is executed in the system control unit 64 to achieve the aforesaid genuine yield-rate test. Note, similar to the provisional yield-rate test routine, the execution of the genuine yield-rate test routine is started by either operating a previously allocated function key on the keyboard 69 or double-clicking the mouse 71 on a yield-rate test routine test staring item displayed on the display unit 70.

At step 1201, it is monitored whether or not a silicon wafer 10 has been positioned at the predetermined position on the test stage 72 by the aforesaid automatic wafer transferring/positioning system. When the positioning of the silicon wafer 10 at the predetermined position is confirmed, the control proceeds to step 1202, in which a wafer-number "WN" of the silicon wafer 10 is detected by analyzing a frame of still image signals obtained from the CCD image sensor 84 through the image signal processor 86.

After the detection of the wafer-number "WN" is completed, the control proceeds to step 1203, a chip table, which is identified by the detected wafer-number "WN", is read from the hard disk 68 through the hard disk drive 66, and is written and develop in the RAM of the system control unit 64.

At step 1204, an examination routine is executed as a subroutine to thereby examine whether each of finished semiconductor devices, which are formed on the chip areas 12 of the silicon wafer 10, is acceptable or unacceptable. Note, the examination routine is explained in detail hereinafter, with reference to Fig. 13.

At step 1205, a yield-rate calculation/evaluation routine is executed as a subroutine to thereby calculate a yield-rate of acceptable finished semiconductor devices on the silicon wafer 10 concerned, and the silicon wafer 10 is evaluated in accordance with the calculated yield-rate. Note, the yield-rate calculation/evaluation routine is explained in detail hereinafter, with reference to Fig. 14.

At step 1206, it is determined whether the genuine yield-rate test routine should be repeated, i.e. whether a silicon wafer 10 remains to be tested. When the existence of a remaining silicon wafer 10 is confirmed, the control returns to step 1201. When there is no silicon wafer to be tested, the routine ends.

Figure 13 shows a flowchart of the examination routine executed in step 1204 of Fig. 12.

At step 1301, a chip-number counter $C_{CN}$ is reset to "1", and, at step 1302, an acceptable-device counter $C_{AC}$ is reset to "0".

At step 1303, a flag data FD is read from an address of the chip table, which corresponds to the chip number "$C_{CN}$", and, at step 1304, it is determined whether the read flag data FD is "1" or "0".

If FD = 1, i.e. if there is no defect in the basic wiring-arrangement section 16 of the finished semiconductor device concerned, the control proceeds to step 1306, in which the test head 74 is moved to the finished semiconductor device (12), which is identified by the chip-number "$C_{CN}$"', by operating the drive circuit 80 under the system control unit 64. At this initial stage, since

$C_{CN}$ = 1, first, the test head 74 is moved from the home position to a position just above the finished semiconductor device (12) identified by the chip-number [001], and is then moved down toward the finished semiconductor device concerned.

At step 1306, it is monitored whether the probe contacts PC of the test head 74 are in contact with the electrode pads 58 (Fig. 6) of the finished semiconductor device identified by the chip-number "$C_{CN}$", and the movement of the test head 74 is stopped when the contact between the probe contacts PC and the electrode pads 58 is confirmed.

At step 1307, an examination of the finished semiconductor device identified by the chip-number "$C_{CN}$" is performed by outputting test signals from the signal processing circuit 82 to some probe contacts PC of the test head 74. Then, at step 1308, it is determined whether the finished semiconductor device concerned is acceptable or unacceptable on the basis of response signals, which are output from other probe contact PC of the test head 74 in response to the aforesaid test signals.

When the finished semiconductor device identified by the chip-number "$C_{CN}$" is acceptable, the control proceeds to step 1309, a count number of the acceptable-device counter $C_{AC}$ is incremented by "1".

On the other hand, when the finished semiconductor device identified by the chip-number "$C_{CN}$" is unacceptable, the control proceeds from step 1308 to step 1310, in which the flag data FD concerned is made to be "0". At this initial stage, since $C_{CN}$ = 1, the flag data FD stored in the address [001] is changed from "1" to "0".

In either case, the control proceeds to step 1311, in which it is determined whether the count number of the chip-number counter $C_{CN}$ has reached "156". When the count number of the chip-number counter $C_{CN}$ has not reached "156", the control proceeds step 1312, in which the count number of the chip-number counter $C_{CN}$ is incremented by "1". Then, the control returns to step 1303.

On the other hand, at step 1304, if FD = 0, i.e. if there is a defect in the basic wiring-arrangement section 16 of the finished semiconductor device concerned, the control skips to step 1311, in which it is determined whether the count number of the chip-number counter $C_{CN}$ has reached "156". When the count number of the chip-number counter $C_{CN}$ has not reached "156", the control proceeds step 1312, in which the count number of the chip-number counter $C_{CN}$ is incremented by "1". Then, the control returns to step 1303.

Thus, the routine including steps 1303 to 1312 is repeatedly executed until the count number of the chip-number counter $C_{CN}$ has reached "156" (step 1311), i.e. until all the 156 finished semiconductor devices have been examined. When the examination of all the finished semiconductor devices is completed, the control returns to step 1204 of Fig. 12.

As is apparent from the foregoing, in the genuine yield-rate test, since only the finished semiconductor devices, in each of which there is no defect in the basic wiring-arrangement section 16 of the finished semiconductor devices on the silicon wafer 10 concerned, are examined, it is possible to efficiently carry out the genuine yield-rate test.

Figure 14 shows a flowchart of the yield-rate calculation/evaluation routine executed in step 1205 of Fig. 12.

At step 1401, the following calculation is carried out:

$$YR_G \leftarrow C_{AC}/156$$

Herein: $YR_G$ is a yield-rate of the acceptable finished semiconductor devices, and is obtained by dividing a count number of the acceptable-device counter $C_{AC}$ by the total number "156" of the finished semiconductor devices formed on the silicon wafer 10 concerned.

At step 1402, it is determined whether or not the yield-rate $YR_G$ is equal to or larger than a given permissible rate $PR_G$, which is previously input to the RAM of the system control unit 64 by suitable operating the keyboard 69. Also, it is possible to optionally vary the permissible rate $PR_G$ by suitably operating the keyboard 69.

At step 1402, when the yield-rate $YR_G$ is equal to or larger than the predetermined permissible rate $PR_G$, the control proceeds to step 1403, in which a pass message is displayed together with the calculated yield-rate $YR_G$ on the display unit 70 to announce that the silicon wafer 10 has passed the genuine yield-rate test. On the other hand, when the yield-rate $YR_G$ is smaller than the predetermined permissible rate $PR_G$, the control proceeds from step 1402 to 1104, in which a not-pass message is displayed together with the calculated yield-rate $YR_G$ on the display unit 70 to announce that the silicon wafer 10 has not passed the genuine yield-rate test.

In either case, at step 1405, the chip table (Fig. 9) is stored as a new one on the hard disk 68 through the hard disk drive 66. At step 1406, it is monitored whether or not the storage of the chip table on the hard disk 68 is completed.

After the completion of the storage of the chip table on the hard disk 68 is confirmed, the control proceeds to step 1407, in which the silicon wafer 10 is transferred to either a pass station or a not-pass station by the aforesaid automatic wafer transferring/positioning system in accordance with the test results. Namely, when the silicon wafer 10 has passed the genuine yield-rate test, it is transferred to the pass station, and, when the silicon wafer 10 has not passed the genuine yield-rate test, it is transferred to the not-pass station.

At step 1408, it is monitored whether or not the transfer of the silicon wafer 10 to either the pass station or a not-pass station is completed. After the completion of the transfer of the silicon wafer 10 to either the pass station or a not-pass station is confirmed, the control returns to step 1205 of Fig. 12.

Figure 15 shows a representative flowchart of the aforesaid production process for producing a plurality of finished semiconductor devices on chip areas 12 defined on a silicon wafer 10.

At step 1501, the wafer 10 is processed such that a basic wiring-arrangement section 16 is formed on each of the chip areas 12, and thus each of the chip areas 12 is produced as a semi-finished semiconductor device on the silicon wafer 10.

At step 1502, the silicon wafer 10 is subjected to the provisional yield-rate test. Namely, the provisional yield-rate routine shown in Fig. 8 is executed in the test system shown in Fig. 7. At step 1503, it is determined whether or not the silicon wafer 10 passes the provisional yield-rate test.

When the silicon wafer 10 passes the provisional yield-rate test, at step 1504, the silicon wafer 10 is further processed such that a customized wiring-arrangement section 48 is formed on each of the basic wire-arrangement sections 16 in accordance with a customer's request, and thus each of the chip areas 12 is substantially produced as a finished semiconductor device on the silicon wafer 10.

After the formation of the customized wiring-arrangement sections 48 on the basic-wiring-arrangement sections 16 is completed, at step 1505, the silicon wafer 10 is subjected to the genuine yield-rate test. Namely, the genuine yield-rate routine shown in Fig. 12 is executed in the test system shown in Fig. 7. At step 1506, it is determined whether or not the silicon wafer 10 passes the genuine yield-rate test.

When the silicon wafer 10 passes the genuine yield-rate test, at step 1504, the silicon wafer 10 is subjected to various processes. For example, each of the finished semiconductor devices is coated with a protective layer, and a plurality of metal bumps are adhered to the electrode pads 58. Thereafter, the silicon wafer 10 is subjected to a dicing process in which the chip areas 12 are cut and separated from each other, resulting in production of complete semiconductor devices.

When the silicon wafer 10 cannot pass either the provisional yield-rate test (step 1503) or the genuine yield-rate test (step 1506), at step 1508, the silicon wafer 10 is returned to a wafer-manufacturing factory. Otherwise, the silicon wafer 10 is scrapped.

Each of the semiconductor devices produced by the production process according to the present invention features the plurality of electrode pads 30 which are left on the uppermost surface of the basic wiring-arrangement section 16 as remains of the examination in which it has been examined, using the electrode pads 30, whether or not there are defects in the basic wiring-arrangement section 16.

With reference to Figs. 16 and 17, a semi-finished semiconductor device, which is produced in accordance with a conventional production process, is shown. Note, in Figs. 16 and 17, which are similar to Figs. 5 and 6, like elements bear like references primed.

Conventionally, the semi-finished semiconductor device is produced by forming a multi-layered wiring-arrangement on each of chip areas 12' on a silicon wafer 10', and the multi-layered wiring-arrangement is composed of a basic wiring-arrangement section 16' formed on each chip area 12', and a custom-purpose wiring-arrangement section 48' formed on the basic wiring-arrangement section 16', as shown in Fig. 16. The basic wiring-arrangement section 16' is composed of metal circuit patterns layers 36', 40' and 44', and insulation layers 38' and 42' alternately laminated on each chip area 12', and the custom-purpose wiring-arrangement section 48' is composed of insulation layers 50' and 54', and metal circuit patterns layers 52' and 56' alternately laminated on the basic wiring-arrangement section 16'. Note, at this time, each of the custom-purpose wiring-arrangement sections 48' on the silicon wafer 10' is still not customized. Namely, an uppermost circuit pattern, which is formed in the uppermost metal circuit pattern layer 56' of each custom-purpose wiring-arrangement section 48', is merely constituted so as to be rearranged in accordance with a customer's request.

As shown in Fig. 17, while the formation of the uppermost metal circuit pattern layer 56' of each custom-purpose wiring-arrangement section 48' is carried out, a plurality of electrode pads 58' and a plurality of conductive leads 60' are simultaneously formed on the insulation layer 54' at an outer peripheral area surrounding the uppermost metal circuit pattern layer 56', with each of the conductive leads 60' integrally extending from a corresponding electrode pad 58'. Also, conventionally, as shown in Fig. 17, if necessary, some additional electrode pads 88 are formed on bottoms of grid-like fine grooves 90 (i.e. scribe lines) defining the chip areas 12', and a conductive lead 92 integrally extends from each of the electrode pads 88. Each of the additional electrode pads 88 is used only as a test pad when the silicon wafer 10' is subjected to a yield-rate test.

The semi-finished semiconductor devices contains a plural ity of input/output buffers formed in the chip area 12', and the conductive leads 60' and 90 are suitably and electrically connected to the input/output buffers through the intermediary of via-holes formed in the insulation layers 38', 42', 50', and 54'. Referring to Fig. 16, an electrical connection of the conductive lead 90 to an active region 34' of the input/output buffer through a via-hole 46' is representatively shown by way of example.

Conventionally, the silicon wafer 10' carrying the plurality of semi-finished semiconductor devices is subjected to a yield-rate test in which each of the semi-finished semiconductor devices is found to be acceptable or unacceptable. When the silicon wafer 10' passes the yield-rate test, the silicon wafer 10' is further processed such that the uppermost circuit pattern, which is formed in the uppermost metal circuit pattern layer 56' of each custom-purpose wiring-arrangement section 48', is rearranged and customized in accordance with a customer's request, resulting in production of the finished semiconductor devices on the silicon wafer 10'.

In particular, the rearrangement or customization is carried out by locally cutting the circuit pattern formed in the uppermost metal circuit pattern layer 56' of the custom-purpose wiring-arrangement section 48', using a photolithography method and an etching method. In the customization using the photolithography method, a photo-resist layer is formed on the uppermost metal circuit pattern layer 56' of the custom-purpose wiring-arrangement section 48', but it is impossible to make a thickness of the photo-resist layer uniform, because the surface of the uppermost metal circuit pattern layer 56' is irregular due to the circuit pattern formed therein. Thus, it is difficult to properly and accurately achieve the customization of the circuit pattern of the uppermost metal circuit pattern layer due to the irregularity of the thickness of the photo-resist layer, and thus the customized circuit pattern is liable to have defects, resulting in a decline in productivity of the finished semiconductor devices.

As is apparent from a comparison of the conventional production process with the production process according to the present invention, the conventional production process is considerably insufficient, because the conventional semi-finished semiconductor device includes both the basic wiring-arrangement section 16' and the custom-purpose wiring-arrangement section 48' whereas the semi-finished semiconductor device according to the present invention includes only the basic wiring-arrangement section 16.

Namely, in the conventional production process, even if a large number of basic wiring-arrangement sections 16' on the silicon wafer 12' have defects, the formation of custom-purpose wiring-arrangement sections 48' on the silicon wafer 10' is still carried out. On the contrary, according to the present invention, when a large number of basic wiring-arrangement section 16 on the silicon wafer 10 have defects, i.e. when the silicon wafer 10 carrying the plurality of semi-finished semiconductor devices cannot pass the provisional yield-rate test, it is possible to prevent the formation of the customized wiring-arrangement sections on the silicon wafer 10.

In the above-mentioned embodiment, although the second wiring-arrangement section 48 is referred to as the customized wiring-arrangement section, it may be formed as a general-purpose wiring-arrangement section. In this case, the completely finished semiconductor devices are produced as standardized semiconductor devices.

Finally, it will be understood by those skilled in the art that the foregoing description is of preferred embodiments of the device and system, and that various changes and modifications may be made to the present invention without departing from the spirit and scope thereof.

## Claims

**1.** A production process for producing a plurality of semiconductor devices on chip areas (12) which are defined on a wafer (10), which production process comprises:

processing said wafer such that each of said chip areas is produced as a semi-finished semiconductor device by forming a first wiring-arrangement section (16) on each of said chip areas;
subjecting said wafer to a provisional yield-rate test in which it is examined whether each of the semi-finished semiconductor devices on said wafer is acceptable or unacceptable; and
further processing said wafer such that each of said chip areas is produced as a finished semiconductor device by forming a second wiring-arrangement section (48) on said first wiring-arrangement section (16) when said wafer passes said provisional yield-rate test.

**2.** A production process as set forth in claim 1, wherein a yield-rate of acceptable semi-finished semiconductor devices is found in said provisional yield-rate test, and it is determined that said wafer (10) has passed said provision yield-rate test when said yield-rate exceeds a predetermined permissible rate.

**3.** A production process as set forth in claim 1, wherein said first wiring-arrangement section (16) is formed as a basic wiring-arrangement section to define plural kinds of basic electronic component formation areas (18, 20, 22, 24, 26) in each of said chip areas (12), and said second wiring-arrangement section (48) is formed as a customized wiring-arrangement section to establish electrical interconnections among said basic electrical component formation areas in accordance with a customer's request.

**4.** A production process as set forth in claim 1, wherein said basic wiring-arrangement section (16) has a plurality of electrode pads (30) formed on an uppermost surface thereof, for carrying out said provisional yield-rate test.

**5.** A production process as set forth in claim 1, further comprising:

subjecting said wafer (10) to a genuine yield-rate test in which it is examined whether each of the finished semiconductor devices on said wafer is acceptable or unacceptable to thereby find a yield-rate of acceptable finished semiconductor devices; and

finally processing said wafer when said wafer passes said genuine yield-rate test.

**6.** A production process as set forth in claim 5, wherein a yield-rate of acceptable finished semiconductor devices is found in said genuine yield-rate test, and it is determined that said wafer (10) has passed said genuine yield-rate test when said yield-rate exceeds a predetermined permissible rate.

**7.** A production process as set forth in claim 5, wherein said customized wiring-arrangement section (48) has a plurality of electrode pads (58) formed on an uppermost surface thereof, and said genuine yield-rate test is carried out, using the electrode pads of said customized wiring-arrangement section.

**8.** A production process as set forth in claim 7, wherein said basic wiring-arrangement section (16) is formed as a multi-layered wiring-arrangement section composed of at least two metal circuit pattern layers (36, 40, 44) and at least one insulation layer (38, 42) alternately laminated on each of said chip areas (12), and said customized wiring-arrangement section (48) is formed as a multi-layered wiring-arrangement section composed of at least two metal circuit pattern layers (52, 56) and at least one insulation layer (54) alternately laminated on said basic wiring-arrangement section.

**9.** A plurality of semi-finished semiconductor devices formed on chip areas (12) defined on a wafer, which comprises:

a wiring-arrangement section (16) formed on each of said chip areas; and

a plurality of electrode pads (30) formed on an uppermost surface of said wiring-arrangement section, said electrode pads being only used to examine whether or not there is a defect in said wiring-arrangement section.

**10.** A plurality of semi-finished semiconductor devices as set forth in claim 9, wherein said wiring-arrangement section (16) is defined as a first wiring-arrangement section, and each of said chip areas is produced as a finished semiconductor device by forming a second wiring-arrangement section (48) on said first wiring-arrangement section.

**11.** A plurality of semi-finished semiconductor devices as set forth in claim 10, wherein said first wiring-arrangement section (16) is formed as a basic wiring-arrangement section to define plural kinds of basic electronic component formation areas (18, 20, 22, 24, 26) in each of said chip areas (12), and said second wiring-arrangement section (48) is formed as a customized wiring-arrangement section to establish electrical interconnections among said basic electrical component formation areas in accordance with a customer's request.

**12.** A plurality of finished semiconductor devices formed on chip areas (12) defined on a wafer, which comprises:

a first wiring-arrangement section (16) formed on each of said chip areas;

a plurality of electrode pads (30) formed on an uppermost surface of said first wiring-arrangement section, said electrode pads being only used to examine whether or not there is a defect in said first wiring-arrangement section;

a second wiring-arrangement section (48) formed on said first wiring-arrangement section; and

a plurality of electrode pads (58) formed on an uppermost surface of said second wiring-arrangement section, said electrode pads being utilized to examine whether or not there is a defect in second wiring-arrangement section.

**13.** A plurality of finished semiconductor devices as set forth in claim 12, wherein said first wiring-arrangement section (16) is formed as a basic wiring-arrangement section to define plural kinds of basic electronic component formation areas (18, 20, 22, 24, 26) in each of said chip areas (12), and said second wiring-arrangement section (48) is formed as a customized wiring-arrangement section to establish electrical interconnections among said basic electrical component formation areas in accordance with a customer's request.

**14.** A semiconductor device comprising:

a chip base (12);

a first wiring-arrangement section (16) formed on said chip base;

a plurality of electrode pads (30) formed on an uppermost surface of said first wiring-arrangement section; and

a second wiring-arrangement section (48) formed on said first wiring-arrangement section,

wherein said plurality of electrode pads are left on the uppermost surface of said first wiring-arrangement section which has been examined, using said electrode pads, to determine whether or not there are defects in said first wiring-arrangement section.

**15.** A semiconductor device as set forth in claim 14, wherein said first wiring-arrangement section (16) is formed as a basic wiring-arrangement section to define plural kinds of basic electronic component formation areas (18, 20, 22, 24, 26) in each of said chip areas (12), and said second wiring-arrangement section (48) is formed as a customized wiring-arrangement section to establish electrical interconnections among said basic electrical component formation areas in accordance with a customer's request.

**16.** A provisional yield-rate test system for testing a wafer (10) having a plurality of semi-finished semiconductor devices formed on each of chip areas (12) defined on said wafer, which comprises:

an examination system (step 804, Fig. 10) that examines whether each of said semi-finished semiconductor devices is acceptable or unacceptable;
a yield-rate calculation system (step 1101) that calculates a yield-rate of acceptable semi-finished semiconductor devices based on the results of examination obtained by said examination system; and
a yield-rate evaluation system (steps 1102, 1103, 1104, and 1107) that evaluates the calculated yield-rate to determine whether or not the wafer should be further processed.

**17.** A provisional yield-rate test system as set forth in claim 16, further comprising a wafer identification system (84, 86, 64, step 802) that identifies the wafer (10) to be tested.

**18.** A provisional yield-rate test system as set forth in claim 16, further comprising a storage system (64, 66, 68, step 1105) that stores the results of examination obtained by said examination system (step 804, Fig. 10).

**19.** A provisional yield-rate test system as set forth in claim 18, wherein the results of examination obtained by said examination system (step 804, Fig. 10) are stored on a storage medium (68) as a chip table (Fig. 9) having a plurality of flag data (FD) corresponding to the chip areas (12) on the wafer.

**20.** A genuine yield-rate test system for testing a wafer (10) having a plurality of finished semiconductor devices formed on each of chip areas (12) defined on said wafer, each of the finished semiconductor devices being formed as a semi-finished semiconductor device by forming a first wiring-arrangement section (16), and being then completed by forming a second wiring-arrangement section (48) on said first wiring-arrangement section, said genuine yield-rate test system comprising:

a storage medium (68) that stores results of examination in which it has been examined whether each of said semi-finished semiconductor devices is acceptable or unacceptable;
a determination system (steps 1303 and 1304) that determines whether each of said semi-finished semiconductor devices has been acceptable or unacceptable;
an examination system (steps 1307 and 1308) that examines whether each of said finished semiconductor devices is acceptable or unacceptable only when it is determined by said determination system that a corresponding semi-finished semiconductor device has been acceptable;
a yield-rate calculation system (step 1401) that calculates a yield-rate of acceptable finished semiconductor devices based on the results of examination obtained by said examination system; and
a yield-rate evaluation system (steps 1402, 1403, 1404, and 1407) that evaluates the calculated yield-rate to determine whether or not the wafer should be further processed.

**21.** A genuine yield-rate test system as set forth in claim 20, further comprising a wafer identification system (84, 86, 64, step 1202) that identifies the wafer (10) to be tested.

**22.** A genuine yield-rate test system as set forth in claim 20, further comprising a storage system (64, 66, 68, step 1405) that stores the results of examination obtained by said examination system (step 1204, Fig. 13).

**23.** A genuine yield-rate test system as set forth in claim 22, wherein the results of examination obtained by said examination system (step 1204, Fig. 13) are stored on a storage medium (68) as a chip table (Fig. 9) having a plurality of flag data (FD) corresponding to the chip areas (12) on the wafer.

Fig. 1

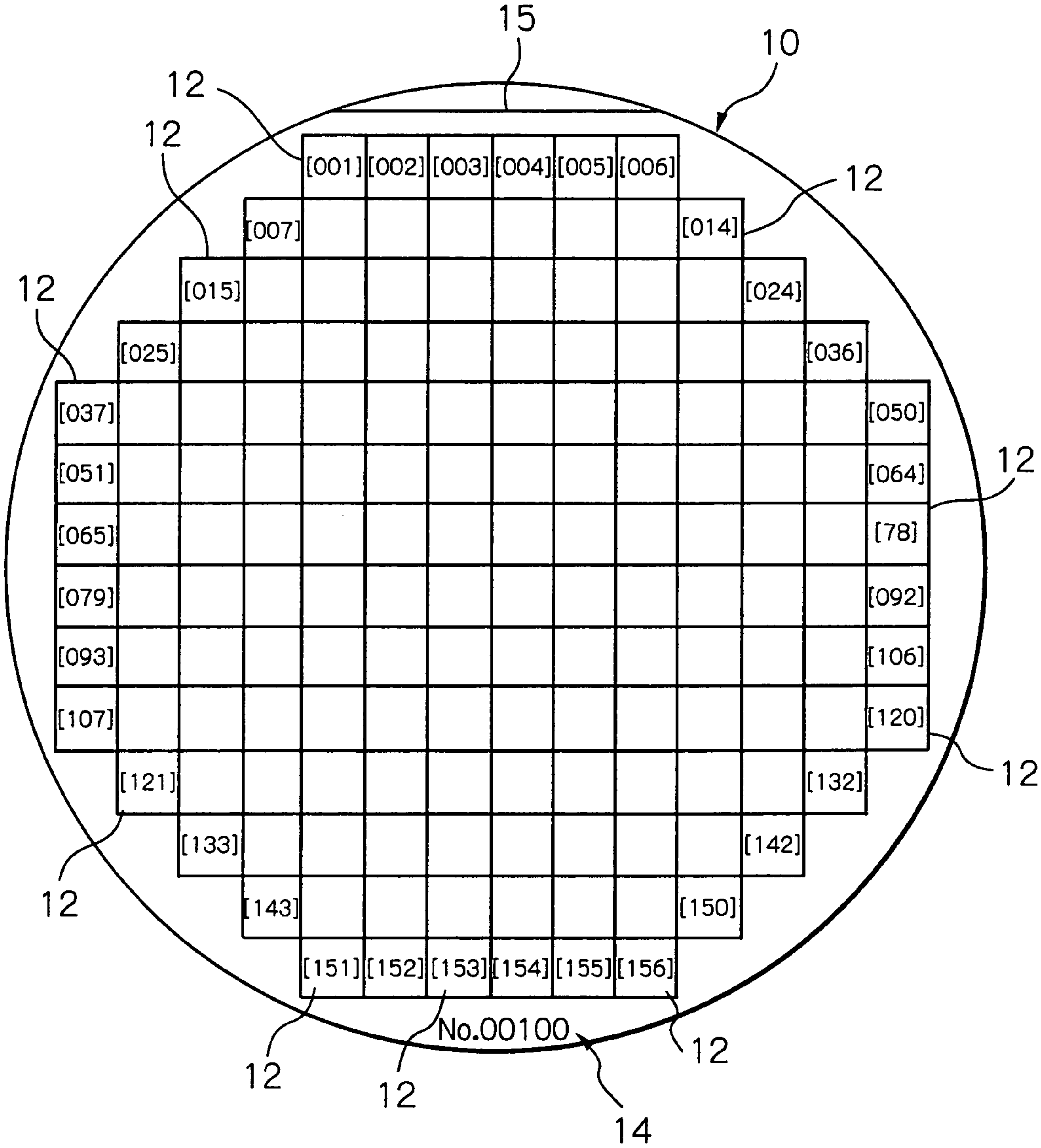
15
10
12
[001]
[002]
[003]
[004]
[005]
[006]
[007]
[014]
[015]
[024]
[025]
[036]
[037]
[050]
[051]
[064]
[065]
[78]
[079]
[092]
[093]
[106]
[107]
[120]
[121]
[132]
[133]
[142]
[143]
[150]
[151]
[152]
[153]
[154]
[155]
[156]
No.00100
14

Fig. 2

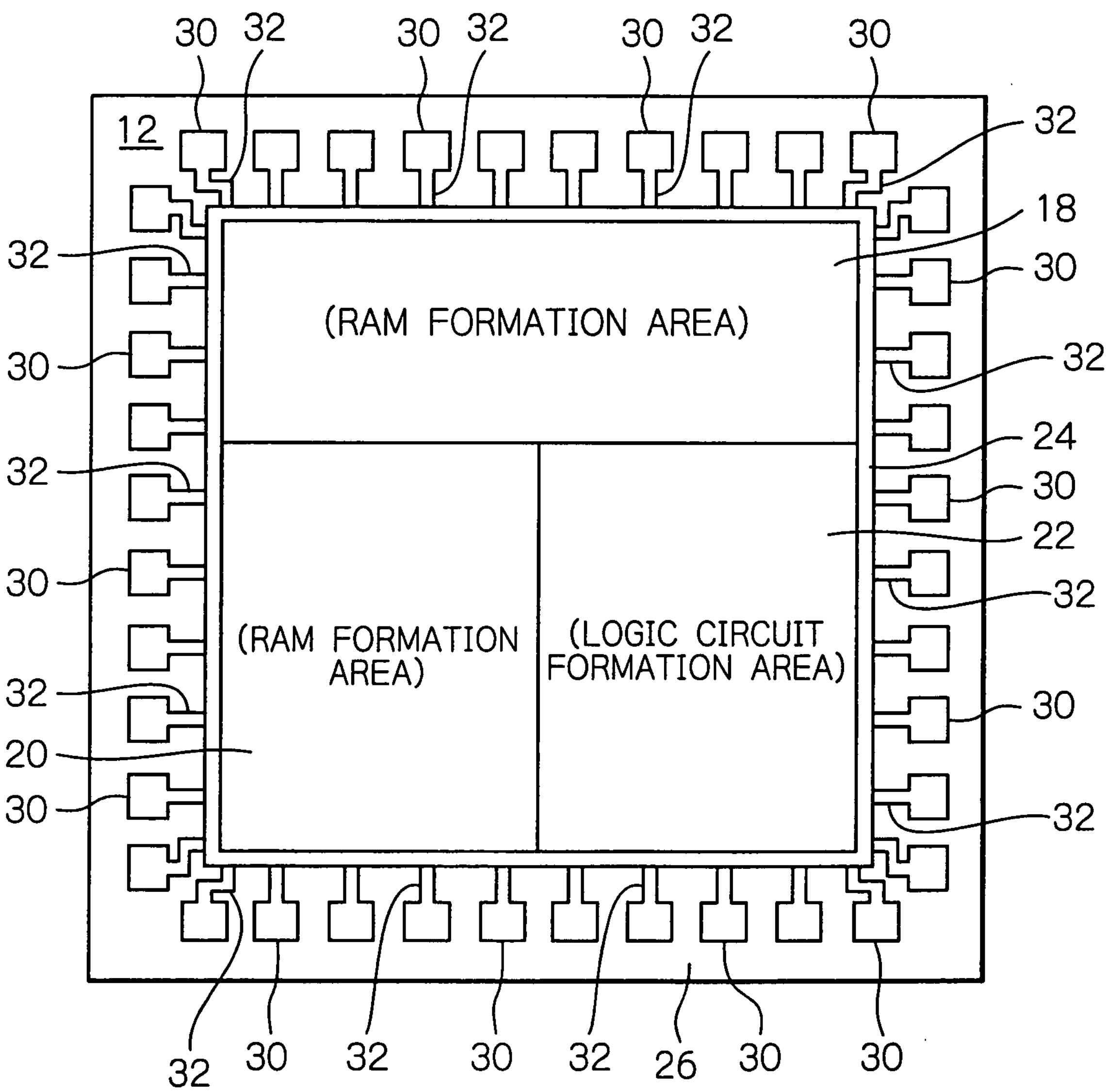
12
30
32
18
24
22
20
26
(RAM FORMATION AREA)
(RAM FORMATION AREA)
(LOGIC CIRCUIT FORMATION AREA)

*Fig. 3*

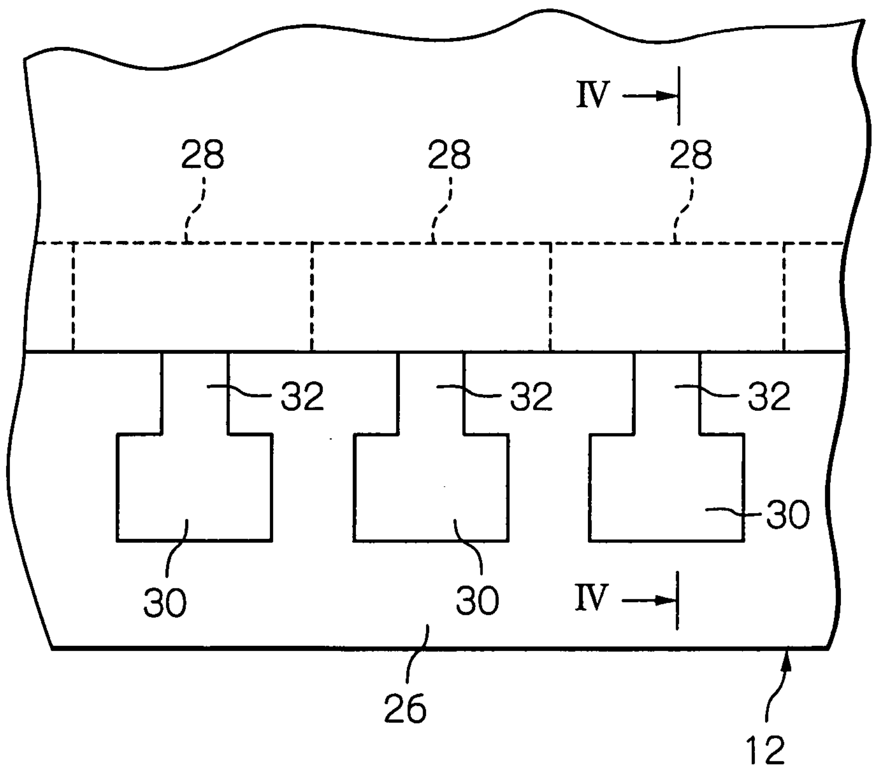

Fig. 4

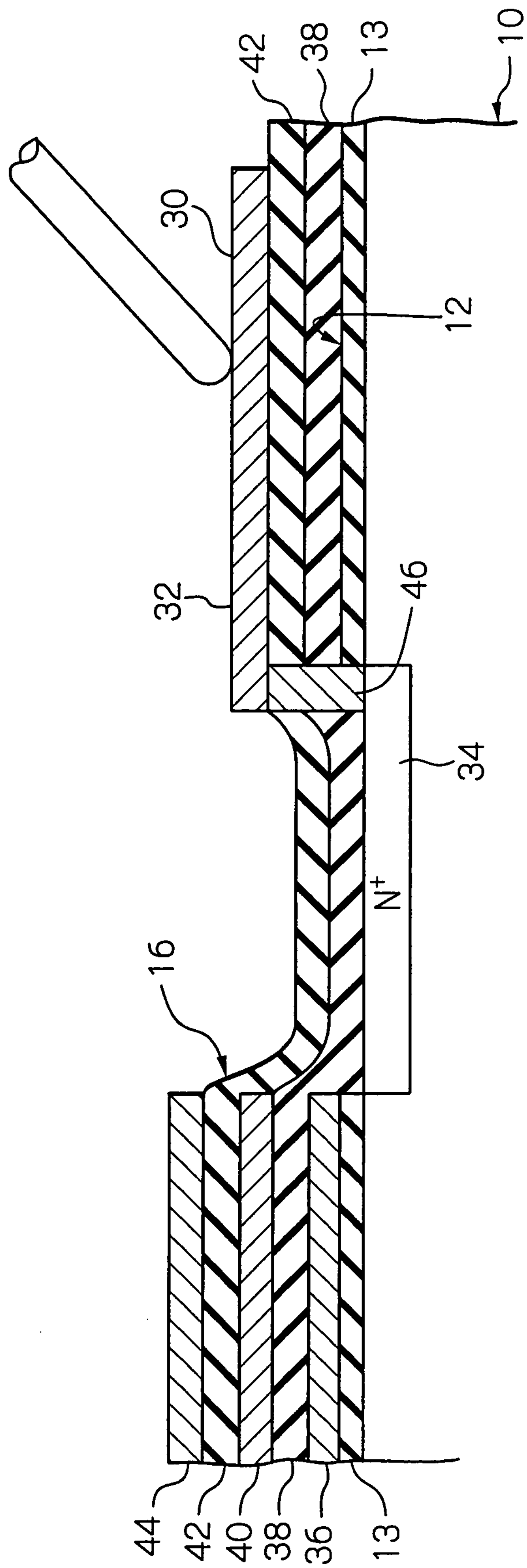

Fig. 5

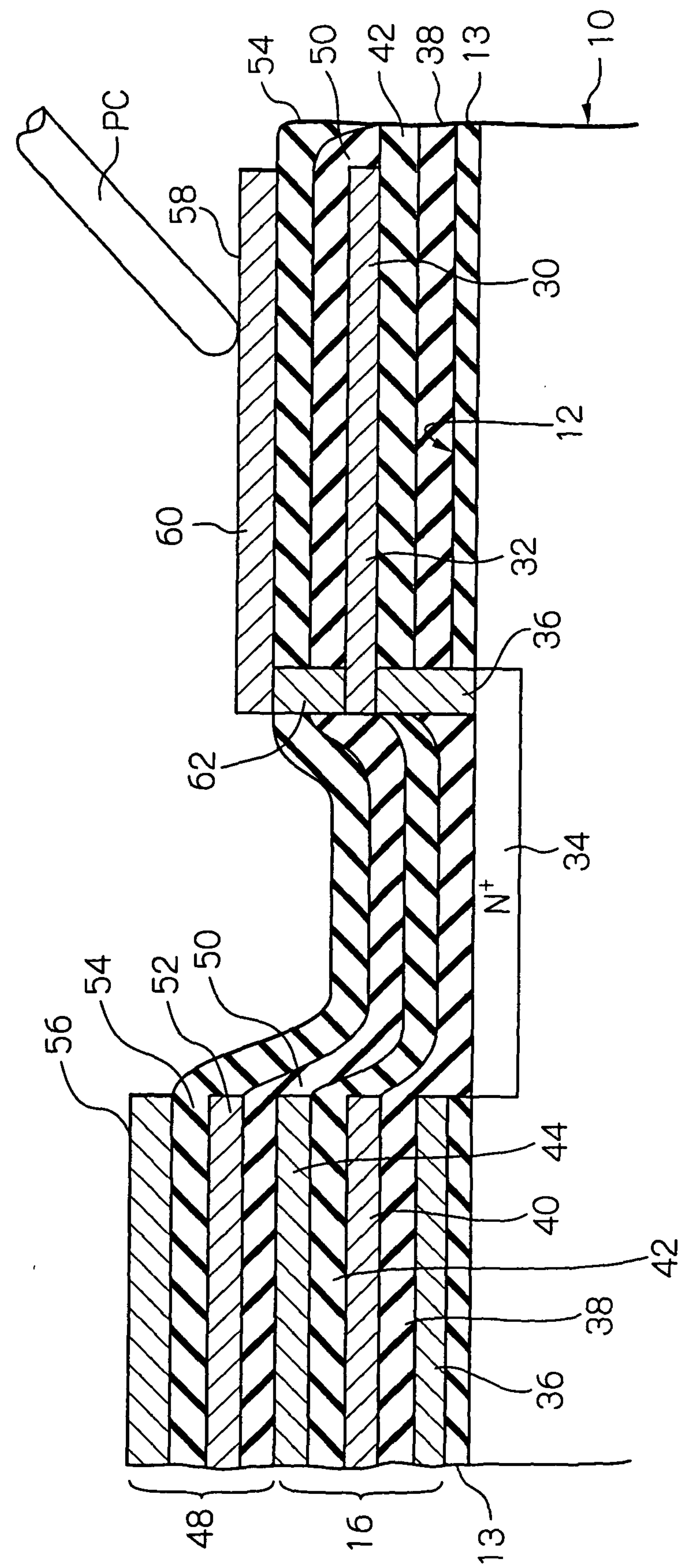
10
13
38
42
50
54
PC
58
30
12
60
32
36
62
34
N+
56
54
52
50
44
40
42
38
36
48
16
13

Fig. 6

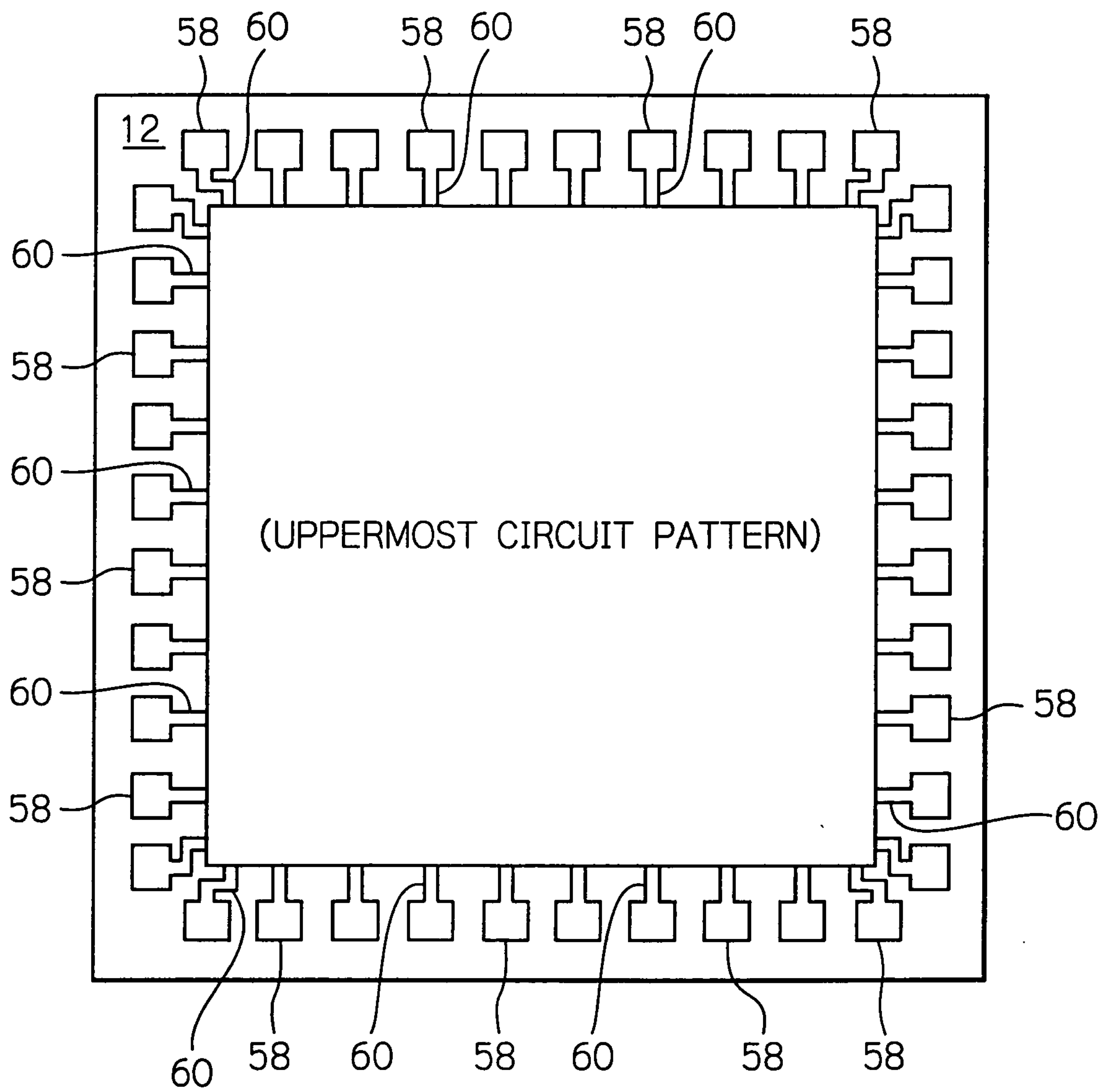

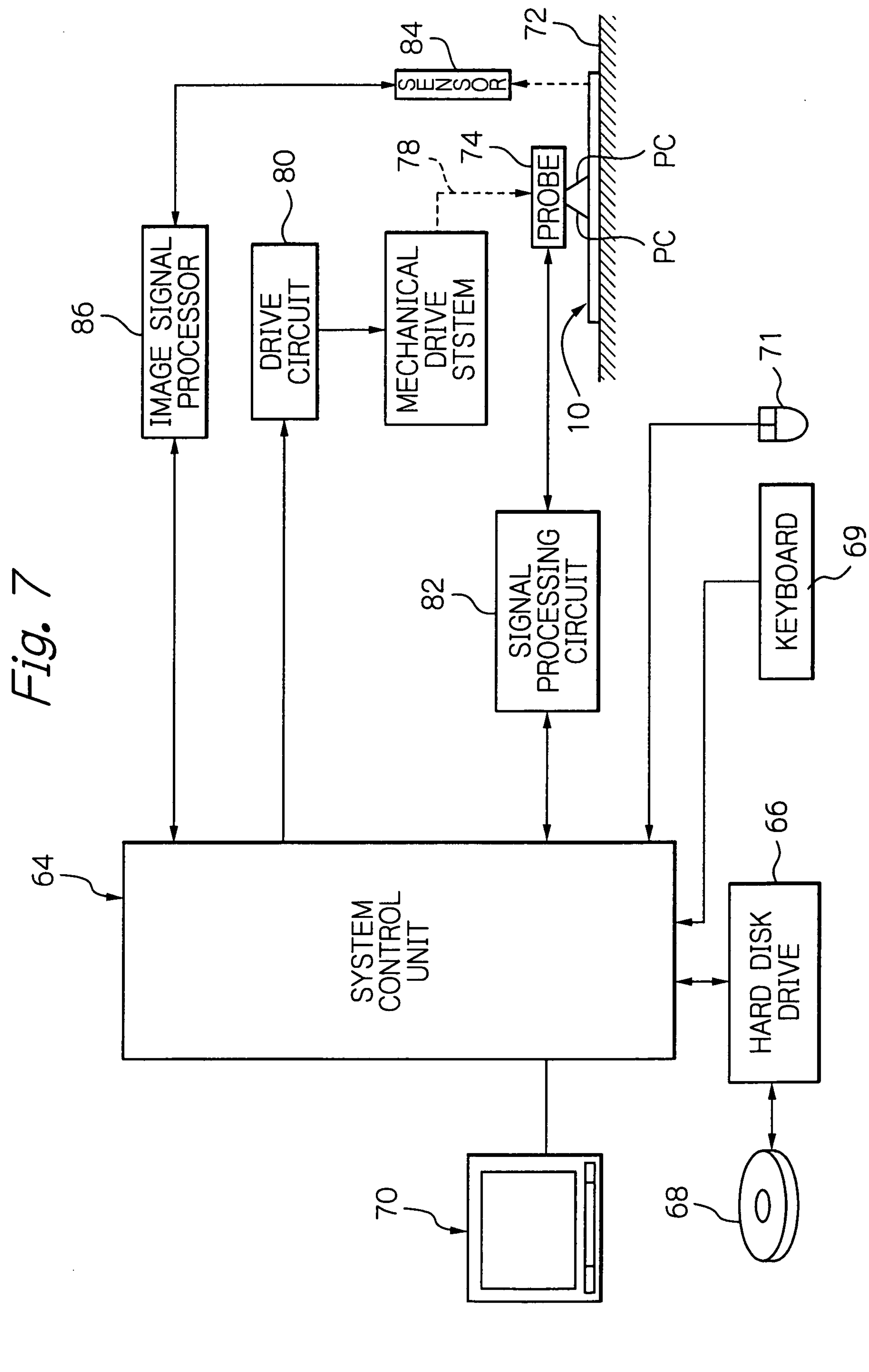
SENSOR
84
72
PROBE
74
78
PC
PC
10
IMAGE SIGNAL PROCESSOR
86
DRIVE CIRCUIT
80
MECHANICAL DRIVE STSTEM
SIGNAL PROCESSING CIRCUIT
82
KEYBOARD
69
71
SYSTEM CONTROL UNIT
64
HARD DISK DRIVE
66
68
70

Fig. 7

*Fig. 8*

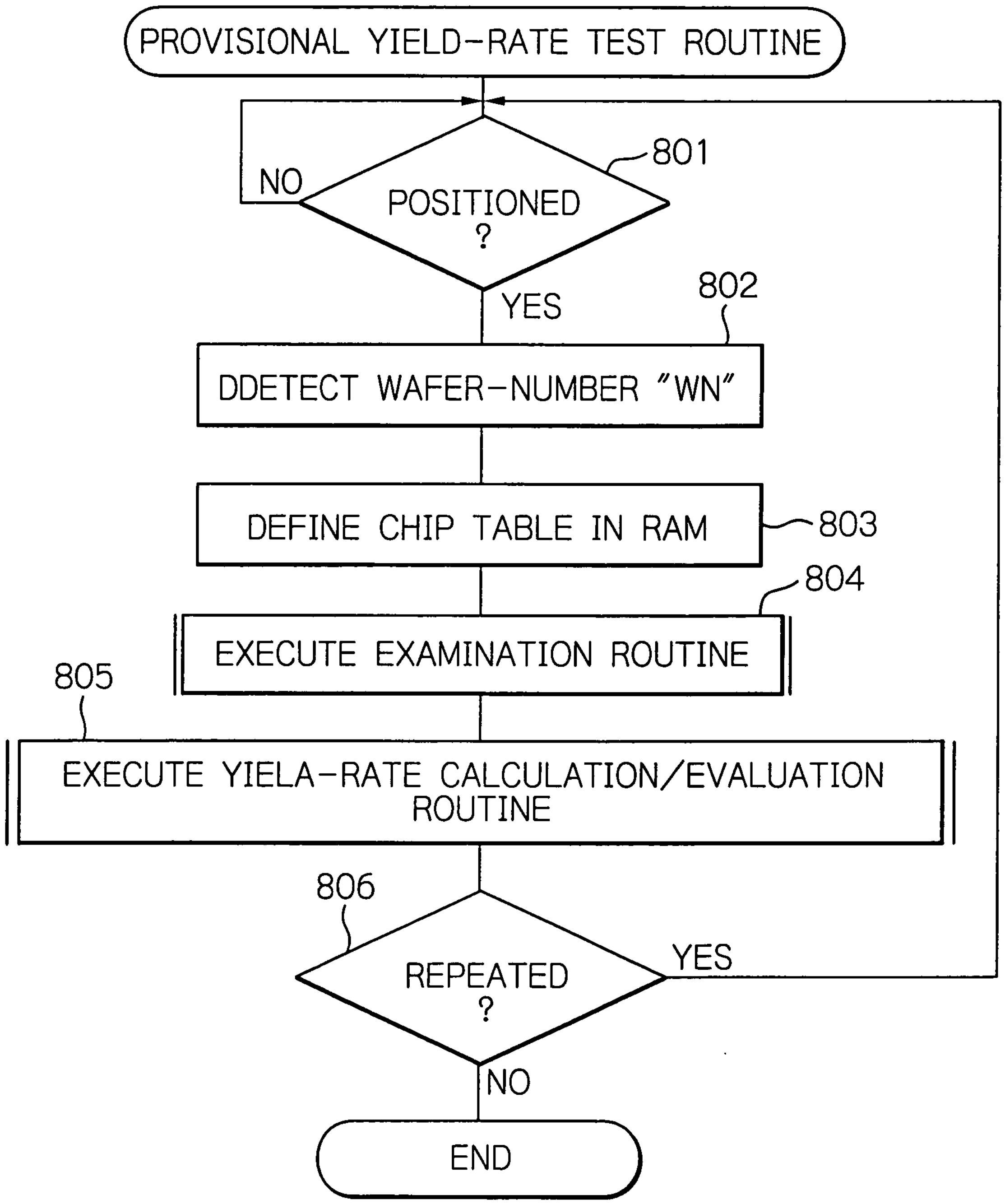
PROVISIONAL YIELD-RATE TEST ROUTINE
801
NO
POSITIONED ?
YES
802
DDETECT WAFER-NUMBER "WN"
DEFINE CHIP TABLE IN RAM
803
804
EXECUTE EXAMINATION ROUTINE
805
EXECUTE YIELA-RATE CALCULATION/EVALUATION ROUTINE
806
REPEATED ?
YES
NO
END

*Fig. 9*

| WN[00100] | | | | | | | | |
|---|---|---|---|---|---|---|---|---|
| [001] | [002] | [003] | [004] | | [153] | [154] | [155] | [156] |
| FD | FD | FD | FD | -------------------- | FD | FD | FD | FD |

Fig. 10

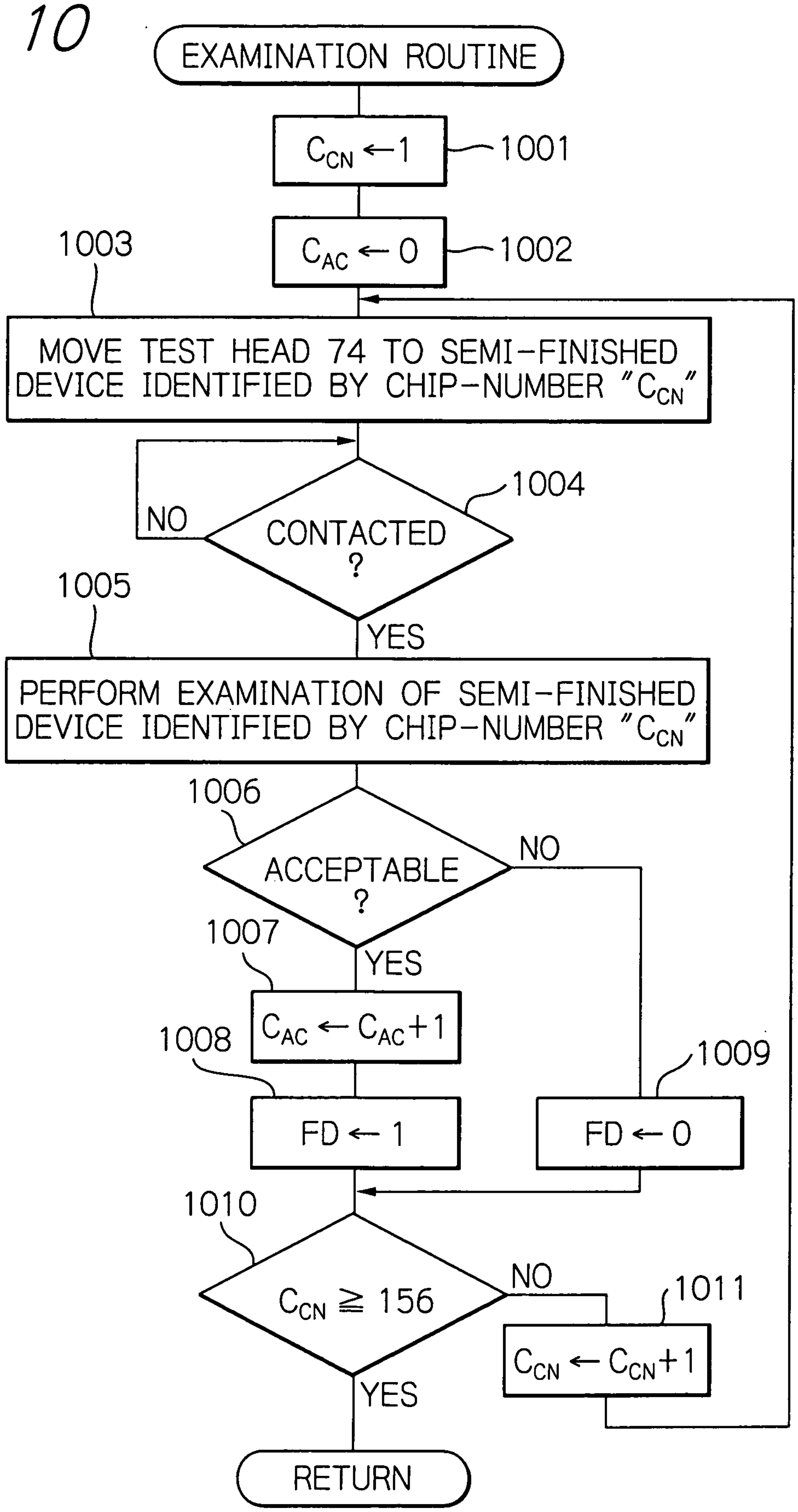
EXAMINATION ROUTINE
$C_{CN}$ ← 1
1001
$C_{AC}$ ← 0
1002
1003
MOVE TEST HEAD 74 TO SEMI-FINISHED DEVICE IDENTIFIED BY CHIP-NUMBER "$C_{CN}$"
1004
CONTACTED ?
NO
YES
1005
PERFORM EXAMINATION OF SEMI-FINISHED DEVICE IDENTIFIED BY CHIP-NUMBER "$C_{CN}$"
1006
ACCEPTABLE ?
NO
YES
1007
$C_{AC}$ ← $C_{AC}$+1
1008
FD ← 1
1009
FD ← 0
1010
$C_{CN}$ ≧ 156
NO
1011
$C_{CN}$ ← $C_{CN}$+1
YES
RETURN

Fig. 11

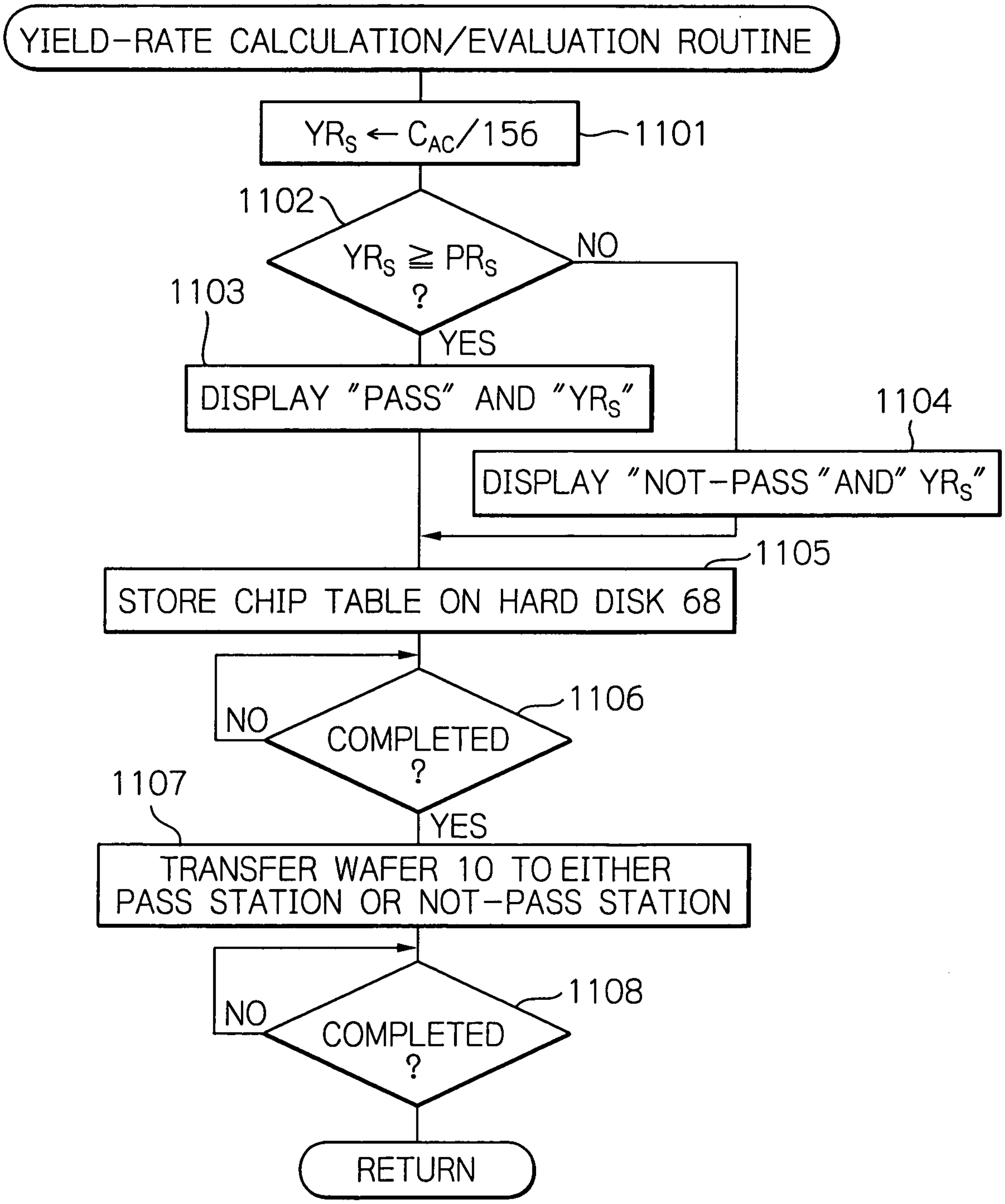
YIELD-RATE CALCULATION/EVALUATION ROUTINE
$YR_S \leftarrow C_{AC}/156$
1101
1102
$YR_S \geqq PR_S$ ?
NO
YES
1103
DISPLAY "PASS" AND "$YR_S$"
1104
DISPLAY "NOT-PASS" AND" $YR_S$"
1105
STORE CHIP TABLE ON HARD DISK 68
1106
COMPLETED ?
NO
YES
1107
TRANSFER WAFER 10 TO EITHER PASS STATION OR NOT-PASS STATION
1108
COMPLETED ?
NO
RETURN

Fig. 12

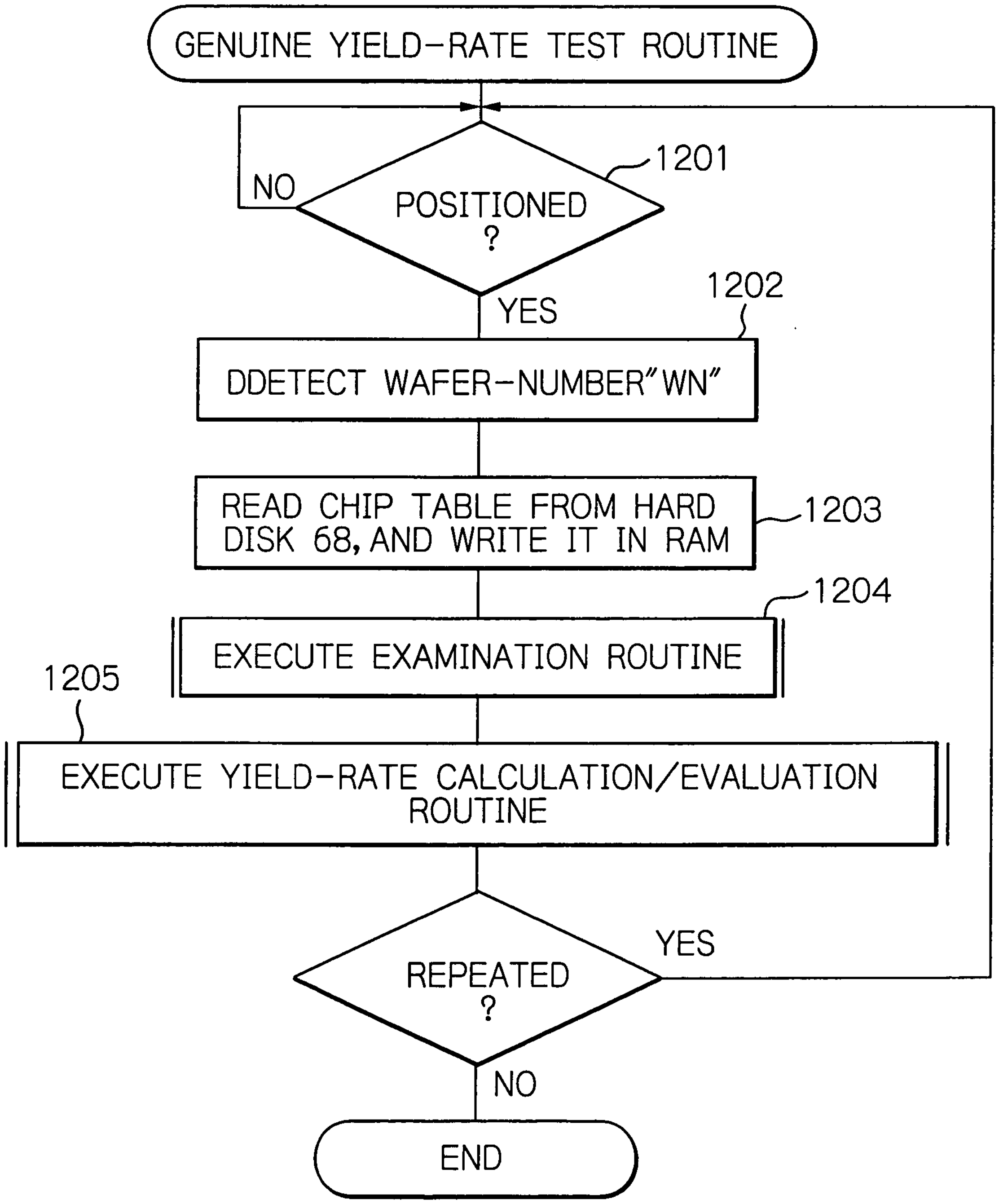
GENUINE YIELD-RATE TEST ROUTINE
NO
POSITIONED ?
1201
YES
1202
DDETECT WAFER-NUMBER"WN"
READ CHIP TABLE FROM HARD DISK 68, AND WRITE IT IN RAM
1203
1204
EXECUTE EXAMINATION ROUTINE
1205
EXECUTE YIELD-RATE CALCULATION/EVALUATION ROUTINE
REPEATED ?
YES
NO
END

Fig. 13

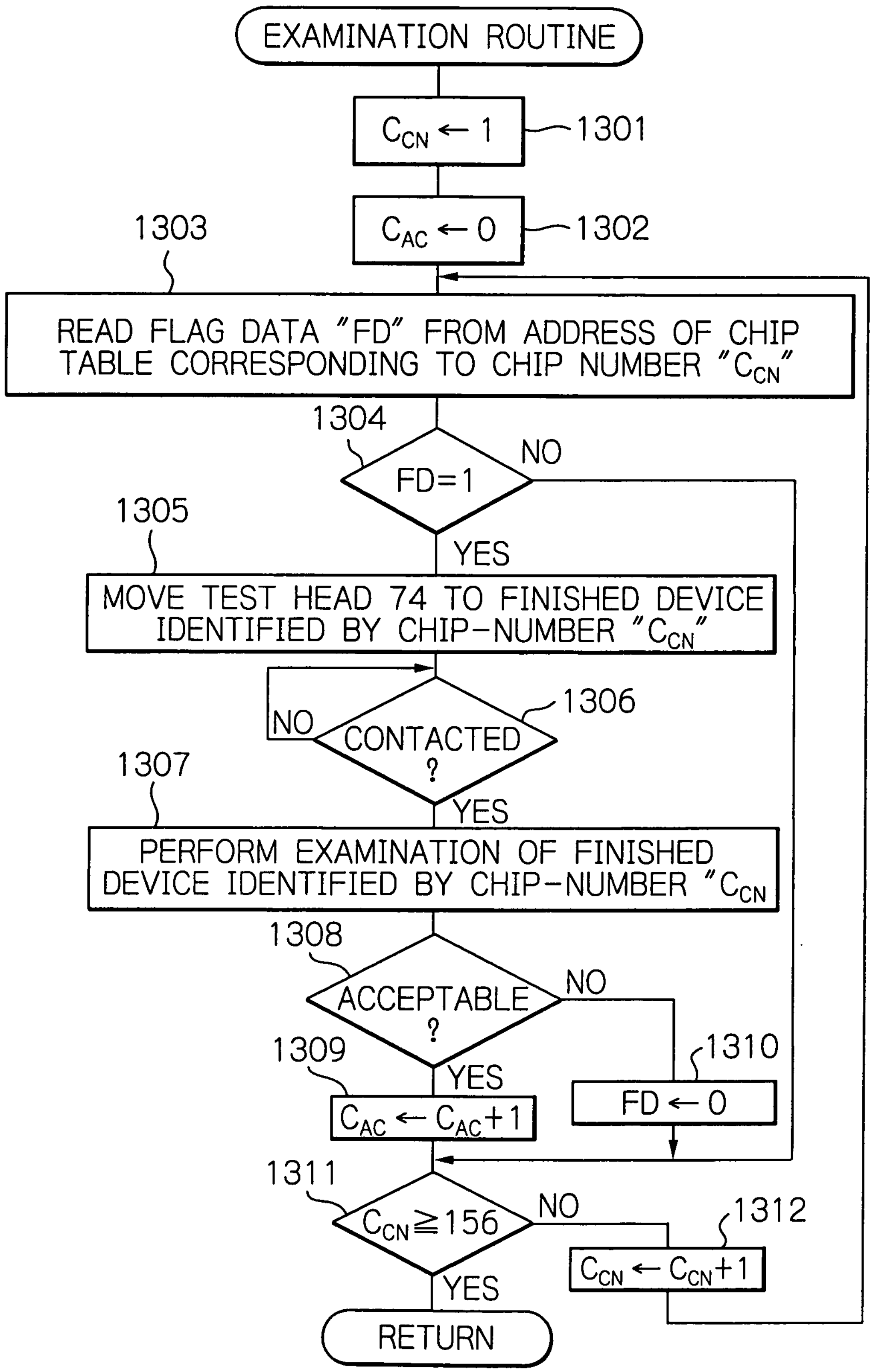
EXAMINATION ROUTINE
C_CN ← 1
1301
C_AC ← 0
1302
1303
READ FLAG DATA "FD" FROM ADDRESS OF CHIP TABLE CORRESPONDING TO CHIP NUMBER "C_CN"
1304
FD=1
NO
YES
1305
MOVE TEST HEAD 74 TO FINISHED DEVICE IDENTIFIED BY CHIP-NUMBER "C_CN"
1306
NO
CONTACTED ?
YES
1307
PERFORM EXAMINATION OF FINISHED DEVICE IDENTIFIED BY CHIP-NUMBER "C_CN
1308
ACCEPTABLE ?
NO
YES
1309
C_AC ← C_AC+1
1310
FD ← 0
1311
C_CN≧156
NO
YES
1312
C_CN ← C_CN+1
RETURN

*Fig. 14*

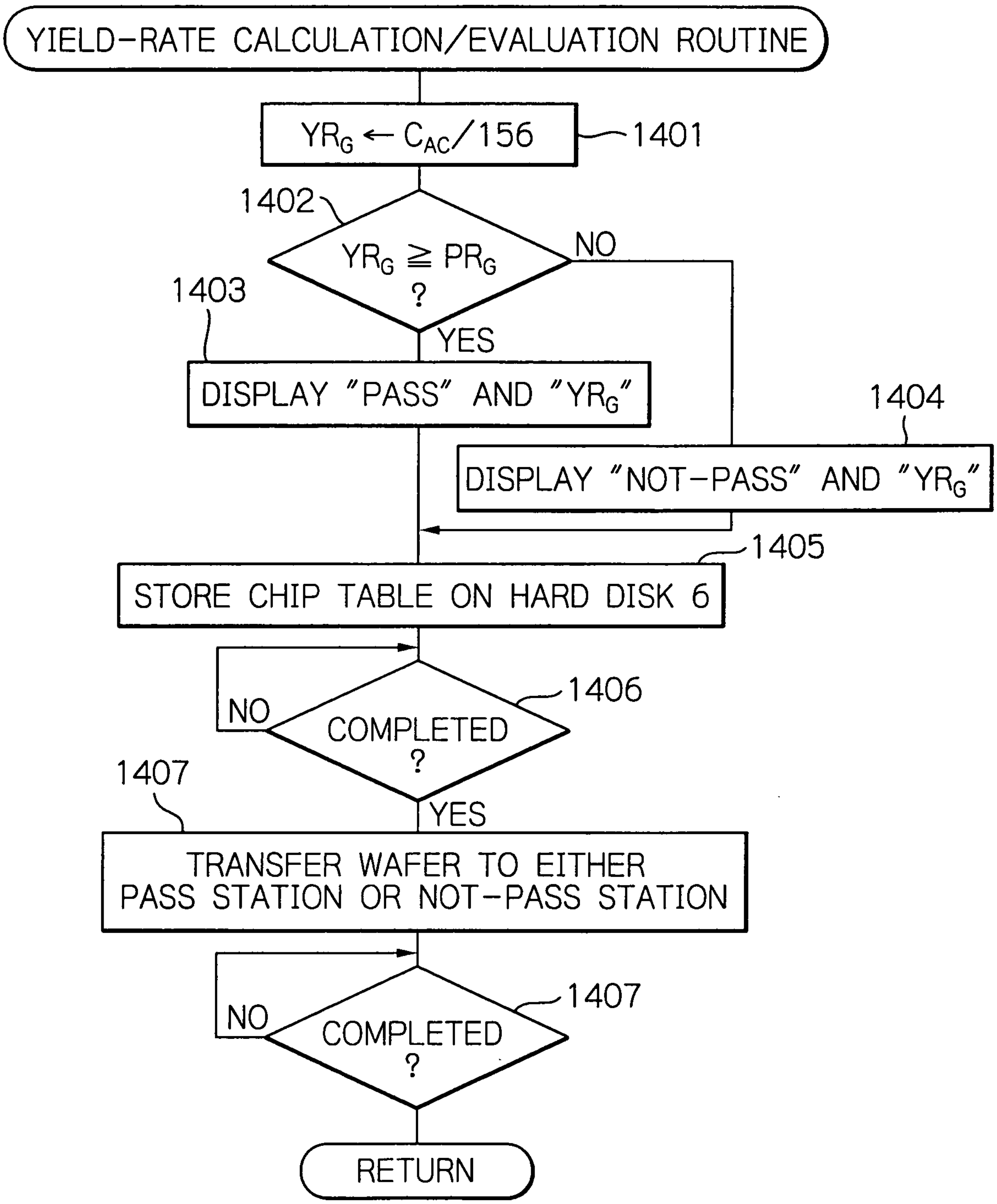

YIELD-RATE CALCULATION/EVALUATION ROUTINE
YRG ← CAC/156
1401
1402
YRG ≧ PRG ?
NO
YES
1403
DISPLAY "PASS" AND "YRG"
1404
DISPLAY "NOT-PASS" AND "YRG"
1405
STORE CHIP TABLE ON HARD DISK 6
NO
COMPLETED ?
1406
YES
1407
TRANSFER WAFER TO EITHER PASS STATION OR NOT-PASS STATION
NO
COMPLETED ?
1407
RETURN

Fig. 15

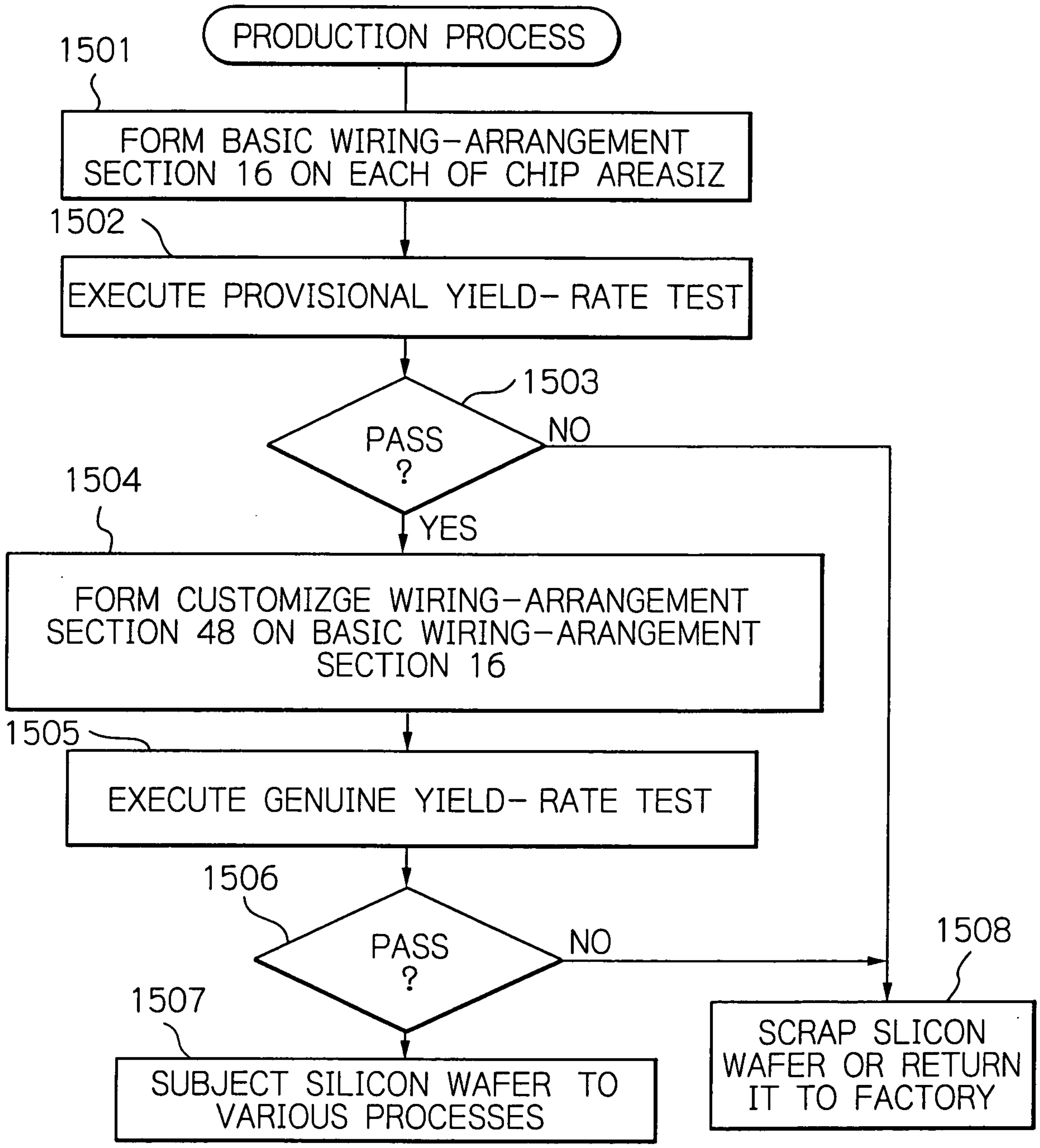
PRODUCTION PROCESS
1501
FORM BASIC WIRING-ARRANGEMENT SECTION 16 ON EACH OF CHIP AREASIZ
1502
EXECUTE PROVISIONAL YIELD- RATE TEST
1503
PASS ?
NO
YES
1504
FORM CUSTOMIZGE WIRING-ARRANGEMENT SECTION 48 ON BASIC WIRING-ARANGEMENT SECTION 16
1505
EXECUTE GENUINE YIELD- RATE TEST
1506
PASS ?
NO
1507
SUBJECT SILICON WAFER TO VARIOUS PROCESSES
1508
SCRAP SLICON WAFER OR RETURN IT TO FACTORY

Fig. 16

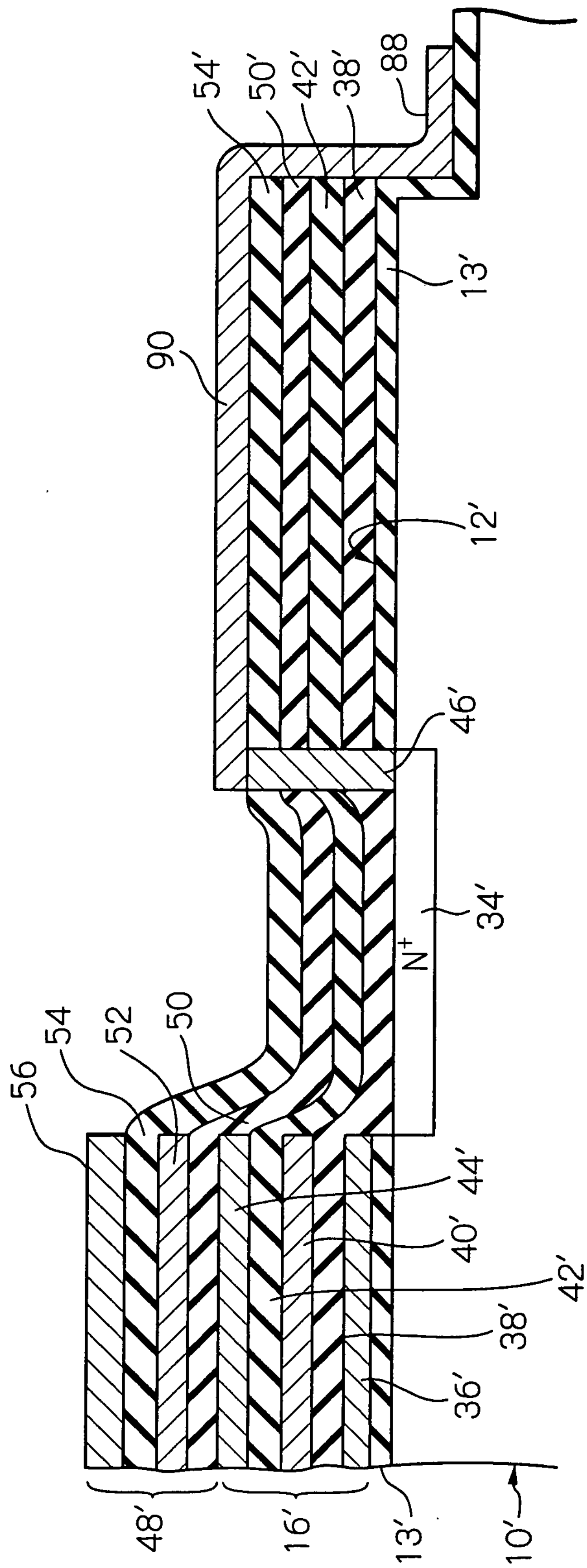

Fig. 17

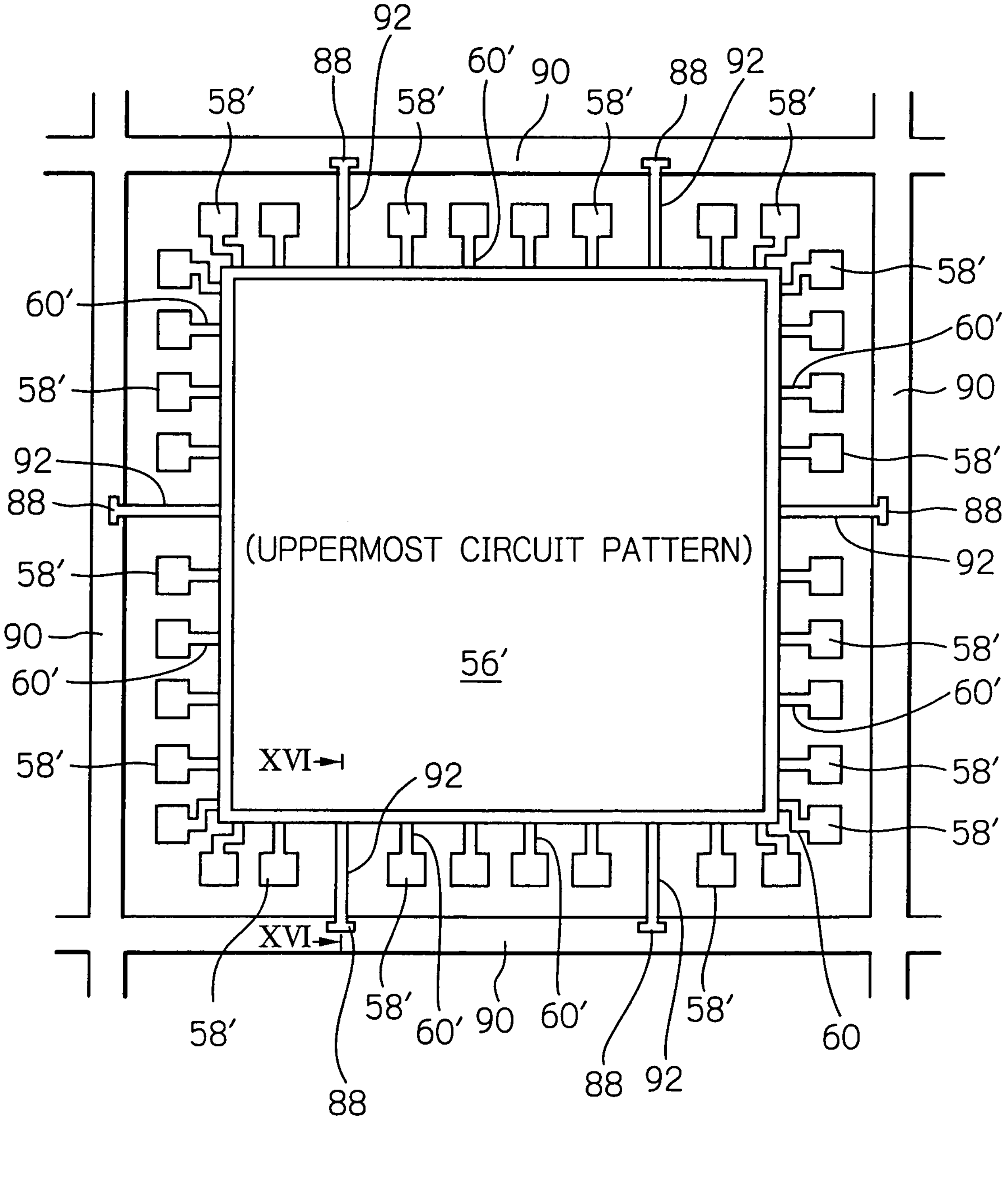
92
88
60′
90
88
92
58′
58′
58′
58′
58′
60′
60′
58′
90
92
58′
88
88
(UPPERMOST CIRCUIT PATTERN)
92
58′
58′
90
56′
60′
60′
58′
XVI
58′
92
58′
XVI
58′
58′
60′
90
60′
58′
60
88
92
88